# EUROPEAN PATENT SPECIFICATION

(11) **EP 2 356 880 B1**
(45) Date of publication and mention of the grant of the patent: **30.03.2016**
(21) Application number: 09814496.7
(22) Date of filing: 02.09.2009
(51) Int. Cl.: H05B 33/02, G09F 9/30, H01L 27/32, H01L 51/50, H05B 33/10, H01L 51/52

(54) **LIGHT-EMITTING DEVICE, PRODUCTION METHOD THEREFOR, AND DISPLAY CONTAINING THE SAME**
LEUCHTBAUELEMENT, HERSTELLUNGSVERFAHREN DAFÜR UND DIESES ENTHALTENDE ANZEIGE
DISPOSITIF ÉLECTROLUMINESCENT, PROCÉDÉ DE FABRICATION ASSOCIÉ, ET AFFICHEUR CONTENANT CE DISPOSITIF

(30) Priority: 22.09.2008 JP 2008243307
(43) Date of publication of application: 17.08.2011
(73) Proprietor: UDC Ireland Limited, Dublin 4 (IE)
(72) Inventor: USAMI, Yoshihisa, Ashigarakami-gun Kanagawa 258-8577 (JP)
(74) Representative: Maiwald Patentanwalts GmbH
(86) International application number: PCT/JP2009/065618
(87) International publication number: WO 2010/032651

(56) References cited:
- EP-A2- 1 480 281
- WO-A1-2005/017860
- WO-A1-2005/017861
- WO-A1-2006/035811
- WO-A1-2008/139370
- JP-A- 2000 284 726
- JP-A- 2002 008 868
- JP-A- 2002 289 358
- JP-A- 2002 324 674
- JP-A- 2006 294 491
- JP-A- 2007 258 113
- US-A1- 2006 113 901
- US-A1- 2006 175 962
- US-A1- 2007 290 607
- KITAMURA M ET AL: "ENHANCED LUMINANCE EFFICIENCY OF ORGANIC LIGHT-EMITTING DIODES WITH TWO-DIMENSIONAL PHOTONIC CRYSTALS", JAPANESE JOURNAL OF APPLIED PHYSICS, JAPAN SOCIETY OF APPLIED PHYSICS, JP, vol. 44, no. 4B, 1 April 2005 (2005-04-01) , pages 2844-2848, XP001245861, ISSN: 0021-4922, DOI: 10.1143/JJAP.44.2844
- WEDGE ET AL: "Surface plasmon-polariton mediated emission of light from top-emitting organic light-emitting diode type structures", ORGANIC ELECTRONICS, ELSEVIER, AMSTERDAM, NL, vol. 8, no. 2-3, 13 March 2007 (2007-03-13), pages 136-147, XP005933426, ISSN: 1566-1199, DOI: 10.1016/J.ORGEL.2006.07.003

## Description

### Technical Field

The present invention relates to a light-emitting device, a production method therefor and a display containing the light-emitting device, more specifically, to light-emitting devices such as an organic electroluminescence device (organic EL device), an inorganic electroluminescence device (inorganic EL device) and a light emitting diode (LED), a production method therefor, and a display containing the light-emitting device.

### Background Art

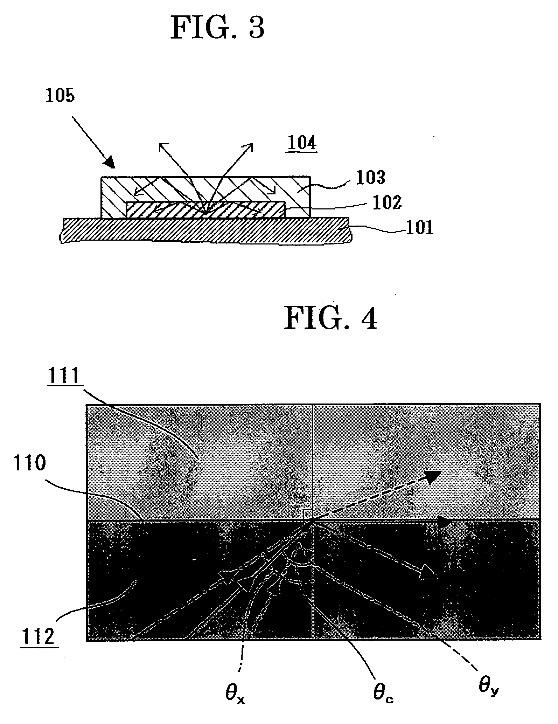

For example, in an organic EL device 105 as shown in FIG. 3, light beams, which have been emitted from an EL light-emitting layer 102 laid on a reflective layer 101, are reflected on the interface between the EL light-emitting layer 102 and a seal layer 103 or between the seal layer 103 and the outside 104, leading to decrease in light-extraction efficiency.

Here, regarding the reflectivity of light on the interface at which refraction of the light occurs, when the interface is flat, the reflectivity depends on the incident angle of the light and the difference in refractive index between media which share the interface. For example, when the difference in refractive index therebetween is large, the reflectivity on the interface becomes high. Also, when light travels from the medium having a high refractive index to that having a low refractive index at an incident angle greater than the critical angle, 100% of the light is reflected.

Critical angle θ_{c} is the minimum incident angle of light at which the light is totally reflected when it travels from a substance having a high refractive index to that having a low refractive index, and expressed by the equation: θ_{c} = arcsin(n₂/n₁), where n₁ denotes a refractive index of a substance through which light travels; n₂ denotes a refractive index of a substance light enters; and n₂ < n₁.

FIG. 4 is an explanatory view used for describing the above phenomenon. In this figure, reference numerals 111 and 112 respectively denote a first layer having a refractive index n₁ and a second layer having a refractive index n₂. Here, when light travels at an incident angle of critical angle θ_{c} with respect to a normal line (standard line) to the interface 110 between the first and second layers, the light is totally reflected on the interface 110 and thus, cannot be extracted from the second layer 112. In addition, light traveling at an incident angle of θₓ greater than critical angle θ_{c} with respect to the standard line is also totally reflected on the interface 110 and thus, cannot be extracted from the second layer 112.

Meanwhile, light traveling at an incident angle of θ_{y} smaller than critical angle θ_{c} with respect to the standard line transmits the interface 110 to be emitted from the second layer 112 to the first layer 111.

Light-emitting devices in which light is totally reflected when being emitted from a high-refractive-index medium to a low-refractive-index medium pose a problem in that the light-extraction efficiency is low.

In view of this, there have been proposed light-emitting devices having various structures, with which the light-extraction efficiency is attempted to be improved.

One proposed light-emitting device is an organic light-emitting device containing a semi-transparent reflective layer having the functions of partially transmitting light emitted from a light-emitting layer to be reached a transparent substrate, and of partially reflecting the light toward a light-emitting layer, wherein the light is reflected toward a light-emitting surface by virtue of resonant effects (cavity effect) (see Patent Literature 1).

This light-emitting device, however, poses a problem in that satisfactory light-extraction efficiency cannot be attained since light emitted from the light-emitting layer toward the semi-transparent reflective layer at an inclined incident angle cannot be reflected toward the light-emitting surface.

Also, another proposed light-emitting device contains a concavo-convex patterned scattering layer at a back surface opposite to a light-emitting surface, wherein the scattering layer reflects/scatters light emitted from a light-emitting layer toward the light-emitting surface for light extraction (see Non-Patent Literatures 1 and 2). Still another proposed light-emitting device is an organic electroluminescence device including an anode, a cathode, one or more organic layers containing a light-emitting layer disposed between the electrodes and a diffracting grating or a zone plate, wherein the diffracting grating or the zone plate is disposed in position for preventing total reflection on the interface in the device (see Patent Literature 2).

Nevertheless, these light-emitting devices pose a problem in that satisfactory light-extraction efficiency cannot be attained since some light scattered/diffracted by the scattering layer/diffracting grating is disadvantageously totally reflected to considerable extent on the interface at which light refraction occurs.

Even if light is extracted from the light-emitting layer, the front brightness may be low since it is difficult to extract the light toward the front surface of the light-emitting layer. In this case, some light emitted from the light-emitting layer is diffused/emitted at a wide angle with respect to the frontal direction. Thus, light-emitting devices each containing a light-emitting layer having a plurality of light-emitting portions involve color mixing between the light-emitting portions.

As described above, the light-emitting devices having the conventional structure are insufficient in light-extraction efficiency, and thus, demand has arisen for development of a light-emitting device which is improved in light-extraction efficiency and front brightness.

Light emitting devices similar to those claimed in the present invention are disclosed, inter alia, in: WO 2008/139370, US 2006/113901 A1, EP 1 480 281 A2, US 2006/175962 A1 and US 2007/290607 A1.

Further background information can also be found in: KITAMURA M ET AL: "ENHANCED LUMINANCE EFFICIENCY OF ORGANIC LIGHT-EMITTING DIODES WITH TWO-DIMENSIONAL PHOTOTONIC CRYSTALS", Japanese Journal of Applied Physics, Japan Society of Applied Physics, JP, vol. 44, no. 4B, 2005, pages 2844 to 2848 and WEDGE ET AL: "Surface plasmon-polariton mediated emission of light from top-emitting organic light-emitting diode type structures", ORGANIC ELECTRONICS, ELSEVIER; AMSTERDAM, NL, vol. 8, no. 2-3, 2007, pages 136 to 147.

### Citation List

### Patent Literature

PTL 1: Japanese Patent Application Laid-Open (JP-A) No. 08-213174
PTL 2: Japanese Patent No. 2991183

### Non Patent Literature

NPL 1: Norihiko Kamiura, four others "Studies on OLED Light Extraction Enhancement" edited by THE INSTITUTE OF ELECTRONICS, INFORMATION AND COMMUNICATION ENGINEERS, TECHNICAL REPORT OF IEICE, EID2007- 102, OME2007-84 (2008-03), pp. 1 to 4
NPL 2: Hiroshi Sano, 12 others "An Organic Light-Emitting Diode with Highly Efficient Light Extraction Using Newly Developed Diffraction Layer," SID 08 DIGEST pp. 515 to 517

### Summary of Invention

An object of the present invention is to provide a light-emitting device which is improved in light-extraction efficiency and front brightness; and a production method for the light-emitting device; and a display containing the light-emitting device. These can solve the above existing problems.

The present inventor conducted extensive studies on the structure with which light can be extracted to the greatest extent possible, while both increasing a light-emitting intensity by virtue of cavity effect and utilizing reflection of light by a fine concavo-convex pattern, and as a result has accomplished the present invention.

Means for solving the above problems are as follows.
< 1 > A light-emitting device comprising, in the order mentioned:
   a light-emitting layer containing two or more light-emitting portions,
   an interference layer,
   an intermediate layer, and
   a fine concavo-convex pattern,
   wherein the interference layer is formed of 2 to 100 layers, is disposed over a second surface of the light-emitting layer which surface is opposite to a first surface of the light-emitting layer, and reflects, toward the first surface, light emitted from the light-emitting layer, and
   wherein the fine concavo-convex pattern has a cross-sectional shape which has portions projected and recessed with respect to the light-emitting layer, and reflects light emitted from the light-emitting layer, and
   wherein at least part of the intermediate layer fills in the spaces of the concavo-convex pattern and has a refractive index of 0.9n to 2.0n, where n denotes a refractive index of the two or more light-emitting portions with respect to light which has a main light-emitting wavelength and is emitted from the light-emitting layer.
< 2 > The light-emitting device according to < 1 > above, wherein the fine concavo-convex pattern has a pitch interval of 0.01λ to 100λ, where λ denotes a main light-emitting wavelength of light emitted from the light-emitting layer.
< 3 > The light-emitting device according to < 1 > or < 2 > above, wherein the fine concavo-convex pattern is made of heat-mode resist.
< 4 > The light-emitting device according to any one of < 1 > to < 3 > above, wherein the fine concavo-convex pattern includes a reflective layer.
< 5 > The light-emitting device according to any one of < 1 > to < 4 > above, wherein a material for the interference layer is any one of TiO₂, SiO₂, SiN, Si₃N₄, Al₂O₃ and a mixture thereof.
< 6 > The light-emitting device according to any one of < 1 > to < 5 > above, wherein at least one of the interference layers has an optical thickness which falls within a range of (2n₃ + 1)λ/4 ± λ/8, where λ and n₃ respectively denote a main light-emitting wavelength of light emitted from the light-emitting layer and a refractive index of the light-emitting layer with respect to light having the main light-emitting wavelength.
< 7 > The light-emitting device according to any one of < 1 > to < 6 > above, wherein the interference layer has a thickness of 1 nm to 10,000 nm.
< 8 > The light-emitting device according to any one of < 4 > to < 7 > above, wherein the reflective layer is laid over at least one surface of the fine concavo-convex pattern.
< 9 > The light-emitting device according to any one of < 1 > to < 8 > above, wherein the light-emitting layer further includes a seal layer for sealing the two or more light-emitting portions, and wherein a material of the seal layer is any of an acrylic resin, an epoxy resin, a fluorine-containing resin, a silicone resin, a rubber resin and an ester resin.
< 10 > The light-emitting device according to any one of < 1 > to < 9 > above, wherein the two or more light-emitting portions are organic EL devices.
< 11 > A production method for the light-emitting device according to any one of < 1 > to < 10 > above, comprising:
   forming a light-emitting layer containing two or more light-emitting portions,
   forming an interference layer over a second surface of the light-emitting layer which surface is opposite to a first surface of the light-emitting layer, the interference layer reflecting, toward the first surface, light emitted from the light-emitting layer, and
   forming, over the interference layer, a fine concavo-convex pattern having a cross-sectional shape which has portions projected and recessed with respect to the light-emitting layer, the fine concavo-convex pattern reflecting light emitted from the light-emitting layer,
   wherein the fine concavo-convex pattern is formed through heat-mode lithography.
< 12 > A display including:
   the light-emitting device according to any one of < 1 > to < 10 > above.
   The present invention can provide a light-emitting device which is improved in light-extraction efficiency and front brightness; and a production method for the light-emitting device; and a display containing the light-emitting device, which can solve the above existing problems.

### Brief Description of Drawings

FIG. 1 is a cross-sectional view of an organic EL device as a light-emitting device of the present invention.
FIG. 2 is an explanatory cross-sectional view for a light-emitting device according to another embodiment of the present invention, and a display containing the light-emitting device.
FIG. 3 is an explanatory cross-sectional view of a conventional light-emitting device.
FIG. 4 is a schematic view used for describing critical angle θc on the interface between first and second layers.

### Description of Embodiments

Next will be described in detail a light-emitting device of the present invention, a production method for the light-emitting device, and a display containing the light-emitting device.

### (Light-emitting device)

A light-emitting device of the present invention includes a light-emitting layer containing two or more light-emitting portions; an interference layer; and a fine concavo-convex pattern in this order. The interference layer is disposed over a second surface of the light-emitting layer which surface is opposite to a first surface of the light-emitting layer, and reflects, toward the first surface, light emitted from the light-emitting layer. The fine concavo-convex pattern reflects light emitted from the light-emitting layer and has a cross-sectional shape which has portions projected and recessed with respect to the light-emitting layer.

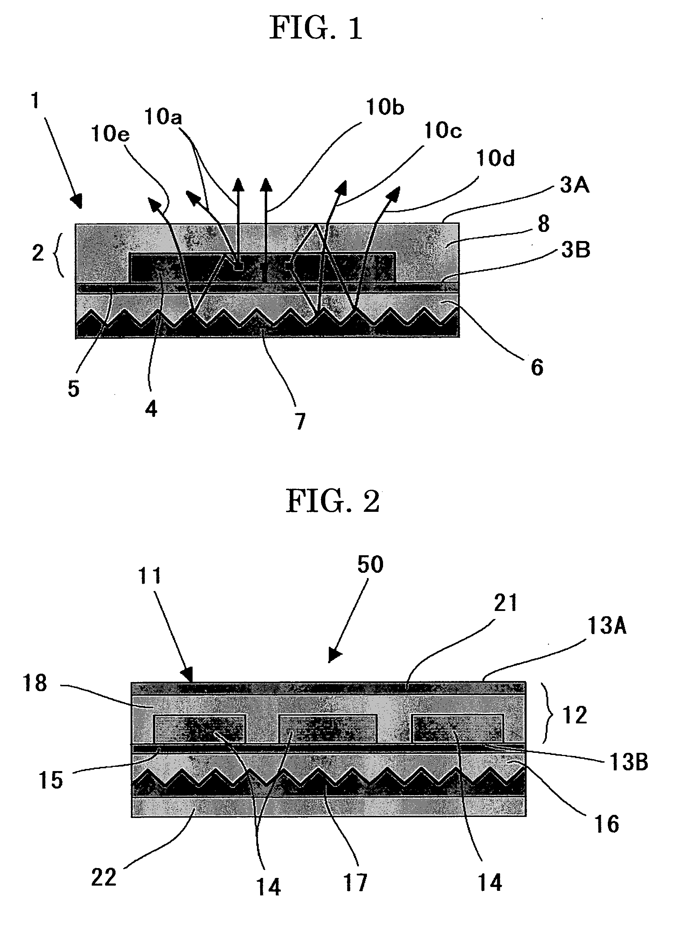

FIG. 1 is a schematic view of the structure of such a light-emitting device of the present invention. In this figure, an interference layer 5 and a fine concavo-convex pattern 7 are disposed in this order over a second surface 3B of a light-emitting layer 2 which surface is opposite to a first surface 3A (light-emitting surface). Also, the intermediate layer 6 is provided between the interference layer 5 and the fine concavo-convex pattern 7.

### < Light-emitting layer >

The light-emitting layer 2 includes a light-emitting portion 4.

The device for the light-emitting portion 4 is not particularly limited and may be appropriately selected depending on the purpose. The light-emitting portion may be, for example, an organic EL device, an inorganic EL device, an LED and a photodiode.

### « Seal layer »

In the light-emitting layer 2, the light-emitting portion 4 is sealed with a seal layer 8.

The seal layer 8 prevents the light-emitting portion 4 from degrading in performance due to oxygen and moisture as a result of exposure to air.

Also, the light-emitting layer 2 may contain a moisture absorbent or an inert liquid. The moisture absorbent is not particularly limited, and specific examples thereof include barium oxide, sodium oxide, potassium oxide, calcium oxide, sodium sulfate, calcium sulfate, magnesium sulfate, phosphorus pentaoxide, calcium chloride, magnesium chloride, copper chloride, cesium fluoride, niobium fluoride, calcium bromide, vanadium bromide, molecular sieve, zeolite and magnesium oxide. Also, the inert liquid is not particularly limited, and specific examples thereof include paraffins; liquid paraffins; fluorine-based solvents such as perfluoroalkanes, perfluoroamines and perfluoroethers; chlorinated solvents; and silicone oils.

The material for the seal layer 8 is not particularly limited, and examples thereof include acrylic resins, epoxy resins, fluorine-containing resins, silicone resins, rubber resins and ester resins. Among them, epoxy resins are preferred from the viewpoint of preventing water permeation. Among the epoxy resins, thermosetting epoxy resins and photo-curable epoxy resins are preferred.

The forming method for the seal layer 8 is not particularly limited, and examples thereof includes a method by coating a resin solution, a method by press-bonding or hot press-bonding a resin sheet, and a method by polymerizing under dry conditions (e.g., vapor deposition and sputtering).

The thickness of the seal layer 8 is preferably 1 µm to 1 mm, more preferably 5 µm to 100 µm, most preferably 10 µm to 50 µm. When the thickness is smaller than 1 µm, the inorganic film may be damaged upon mounting of the substrate. Whereas when the thickness is greater than 1 mm, the light-emitting layer 2 becomes disadvantageously thick.

The light-emitting layer 2 may contain a sealing adhesive having the function of preventing permeation of moisture or oxygen from the edges thereof.

The material for the sealing adhesive may be those used in the seal layer 8. Among them, epoxy resins are preferred from the viewpoint of preventing water permeation. Among the epoxy resins, photo-curable epoxy resins and thermosetting epoxy resins are preferred.

Also, a filler is preferably added to the above materials.

The filler to be incorporated into the seal layer 8 is preferably inorganic materials such as SiO₂, SiO (silicon oxide), SiON (silicon oxynitride) and SiN (silicon nitride). The addition of the filler increases the viscosity of the sealant to improve production suitability and humidity resistance.

The sealing adhesive may also contain a desiccant. The desiccant is preferably barium oxide, calcium oxide or strontium oxide.

The amount of the desiccant added to the sealing adhesive is preferably 0.01% by mass to 20% by mass, more preferably 0.05% by mass to 15% by mass. When the amount is less than 0.01% by mass, the desiccant exhibits reduced effects. Whereas when the amount is more than 20% by mass, it is difficult to homogeneously disperse the desiccant in the sealing adhesive, which is not preferred.

In the present invention, the sealing adhesive containing the desiccant is applied in a predetermined amount using, for example, a dispenser. Thereafter, a second substrate is overlaid, followed by curing, to thereby obtain a functional device.

With respect to light having a main light-emitting wavelength λ (for example, 550 nm, the same applies hereinafter), the refractive index n₁ of the medium (seal layer 8) of the light-emitting layer 2 is about 1.5, the refractive index n₂ of air is about 1.0, and the refractive index n₃ of the light-emitting portion 4 is about 1.8.

Here, in the present invention, total reflection between the layers having different refractive indices is considered, and the refractive indices of them are not limited to the above values.

Notably, the main light-emitting wavelength refers to a peak wavelength.

The forming method for the light-emitting layer 2 is not particularly limited and may be appropriately selected depending on the purpose. For example, the light-emitting layer can be formed by sequentially forming the light-emitting portion 4 and the seal layer 8 with a vacuum film-forming method (e.g., vapor deposition).

### < Interference layer >

The interference layer 5 reflects, in the opposite direction (toward the front surface of the light-emitting device 1), light which is virtually perpendicular to the interference layer 5 and which is emitted from the second surface 3B of light-emitting layer 2, and emits the light outside after amplification by, for example, optical resonant effects (cavity effect).

Also, the interference layer 5 transmits light incident at an inclined angle to the interference layer, and guides the light toward the fine concavo-convex pattern 7.

The material for the interference layer 5 is not particularly limited and may be appropriately selected depending on the purpose. Examples thereof include TiO₂, SiO₂, SiN, Si₃N₄, Al₂O₃ and mixtures thereof. The device ratio of each of these compounds is an ideal one and may be changed depending on a selected film-forming method.

Among them, Al₂O₃ and mixtures containing it are preferred from the viewpoint of forming a dense layer.

Although the interference layer 5 may be a single layer, it is preferably formed of a plurality of layeres.

When the interference layer 5 is formed of a plurality of layers, the minimum number of the layers is preferably 2 or more, 3 or more, 5 or more, or 10 or more.

Also, the maximum number of the interference layers 5 is preferably 100 or less, 50 or less, or 30 or less.

Provision of 2 or more interference layers 5 is advantageous in that the light quantity is increased by virtue of interference effects. Also, when the number of the interference layers is 100 or less, it is advantageous in that easy film formation is allowed and in that the light-use efficiency is prevented from being reduced due to, for example, scattering between interfaces.

Regarding the optical thickness of the interference layers 5, the optical thickness of at least one of the layers falls within a range of (2n₃ + 1)λ/4 ± λ/8, where λ and n₃ respectively denote a main light-emitting wavelength and the refractive index of the light-emitting portion 4 with respect to light having the main light-emitting wavelength. Preferably, 2 or more interference layers have an optical thickness which satisfies the above relation. More preferably, 3 or more interference layers have an optical thickness which satisfies the above relation.

When 2 or more interference layers have an optical thickness which satisfies the above relation, the light quantity is advantageously increased by virtue of interference effects.

Notably, the optical thickness is defined as a product of the actual thickness of each interference layer 5 and the refractive index n₄ thereof with respect to light having a wavelength of λ (main light-emitting wavelength).

The actual thickness of the interference layer 5 is not particularly limited and may be appropriately selected depending on the purpose. From the viewpoints of easy formation, durability to defects (e.g., crack), and prevention of blur of the formed image due to internal waveguide, the minimum thickness is preferably 1 nm or more, 10 nm or more, 20 nm or more, or 30 nm or moreand the maximum thickness is preferably 10,000 nm or less, 1,000 nm or less, 500 nm or less, or 200 nm or less.

The forming method for the interference layer 5 is not particularly limited and may be appropriately selected depending on the purpose. Examples thereof include various sputtering methods, vapor deposition methods, ion beam methods, and CVD methods.

Among them, RF sputtering is preferred from the viewpoint of forming a dense layer.

### < Intermediate layer >

The intermediate layer 6 fills in the spaces of the concavo-convex pattern instead of air, to thereby prevent reflection on the interface and improve its durability. Notably, the intermediate layer 6 may have a single- or multi-layered structure.

The material for the intermediate layer 6 is not particularly limited and may be appropriately selected depending on the purpose. Examples thereof include those having a light absorption peak wavelength (e.g., dyes). When such materials are used, there can be employed light whose wavelength is longer than their light absorption peak wavelength. Also, the intermediate layer is formed by, for example, dispersing high-refractive-index microparticles (e.g., TiO₂ and ZrO₂) in a resin (e.g., an acrylic resin, a polycarbonate resin and a TAC resin).

The thickness of the intermediate layer 6 is not particularly limited and may be appropriately selected depending on the purpose. It is preferably 0.1 µm to 500 µm from the viewpoint of desired film formation. Also, the minimum thickness is more preferably 0.5 µm or more, particularly preferably 2 µm or more. The maximum thickness is more preferably 100 µm or less, particularly preferably 50 µm or less.

The refractive index n₅ of the intermediate layer 6 is not particularly limited and may be appropriately selected depending on the purpose. Preferably, it is adjusted as follows.

Specifically, in at least part of the intermediate layer 6, the minimum refractive index is preferably 0.9n₃ or more, more preferably 0.95n₃ or more, particularly preferably 1n₃ or more, and the maximum refractive index is preferably 2.0n₃ or less, more preferably 1.5n₃ or less, particularly preferably 1.2n₃ or less, where n₃ denotes a refractive index of the light-emitting portion 4 with respect to light having the main light-emitting wavelength.

When the minimum refractive index is 0.9n₃ or more, reflection on the interface can be advantageously reduced. Whereas when the maximum refractive index is 2.0n₃ or less, a material absorbing less light can be selected, which is advantageous.

Also, from the viewpoint of stability of the material, the minimum value of the specific refractive index n₅ of the intermediate layer 6 is preferably 1.55 or more, more preferably 1.65 or more, particularly preferably 1.7 or more; and the maximum value thereof is preferably 3.0 or less, more preferably 2.6 or less, particularly preferably 2 or less.

The forming method for the intermediate layer 6 is not particularly limited and may be appropriately selected depending on the purpose. Examples thereof include spin coating, ink-jet coating and slit coating.

Among them, spin coating is preferred from the viewpoint of attaining uniform coating.

### < Fine concavo-convex pattern >

The fine concavo-convex pattern 7 reflects light transmitted through the interference layer 5 toward the first layer 3A of the light-emitting layer 2 for light extraction.

The shape of the fine concavo-convex pattern 7 is not particularly limited, so long as the cross-sectional shape thereof has portions projected and recessed with respect to the light-emitting layer 2, and may be, for example, a saw-like shape, a bellows-like shape and a square shape.

The pitch interval of the fine concavo-convex pattern 7 is not particularly limited and may be appropriately selected depending on the purpose. From the viewpoint of increase in light quantity, the minimum pitch interval is preferably 0.01λ or more, more preferably 0.05λ or more, still more preferably 0.1λ or more, particularly preferably 0.2λ or more; and the maximum pitch interval is preferably 100λ or less, more preferably 50λ or less, still more preferably 20λ or less, particularly preferably 10λ or less. Here, λ denotes a main light-emitting wavelength.

From the viewpoint of stable pattern formation, the minimum value of the specific pitch interval of the fine concavo-convex pattern 7 is preferably 50 nm or more, more preferably 100 nm or more, still more preferably 200 nm or more, particularly preferably 300 nm or more; and the maximum value thereof is preferably 10 µm or less, more preferably 6 µm or less, still more preferably 3 µm or less, particularly preferably 1 µm or less.

The forming method for the fine concavo-convex pattern 7 is not particularly limited and may be appropriately selected depending on the purpose.

For example, a light-absorbing resist (heat-mode resist) is applied, and the thus-applied resist is treated through heat-mode lithography.

Alternatively, a light-absorbing resist is applied and treated through heat-mode lithography to prepare a pattern (which is not necessarily made of metal). And, the pattern is used for shape transfer through imprinting or molding.

When formed in the above-described manner, the fine concavo-convex pattern can have a complicated shape containing a high-frequency component, and thus is improved in light controllability.

### « Reflective layer »

A reflective layer (not shown) may be formed on at least one surface of the fine concavo-convex pattern 7. Notably, the fine concavo-convex pattern 7 itself may be made of light-reflective material.

The material for the reflective layer is not particularly limited and may be appropriately selected depending on the purpose. Ag, Al, etc. are preferred from the viewpoint of attaining high reflectivity.

The thickness of the reflective layer is not particularly limited and may be appropriately selected depending on the purpose. It is preferably 10 nm to 10,000 nm. Also, the minimum thickness is more preferably 50 nm or more, particularly preferably 100 nm or more. The maximum thickness is more preferably 2,000 nm or less, particularly preferably 1,000 nm or less.

The reflective layer having a thickness of 10 nm or more is advantageous in terms of high reflectivity. The reflective layer having a thickness of 10,000 nm or less is advantageous in terms of film formation.

The forming method for the reflective layer is not particularly limited and may be appropriately selected depending on the purpose. Examples thereof include various sputtering methods, vapor deposition methods and ion plating methods.

Among them, DC sputtering is preferred from the viewpoint of attaining high reflectivity.

With reference to FIG. 1, next will be described the operation of the light-emitting device 1 having the above-described structure (see FIG. 4 in relation to critical angle θ_{c}, etc.).

### (1-1) Interface between light-emitting portion and seal layer

Light beams 10a and 10d which are emitted from the light-emitting portion 4 toward the first surface 3A of the light-emitting layer 2 and whose incident angles are θ_{y1} smaller than critical angle θ_{c1} pass through the interface between the light-emitting portion 4 and the seal layer 8 to enter the seal layer 8.

Meanwhile, light beam 10e whose incident angle is critical angle θ_{c} or angle θₓ₁ greater than critical angle θ_{c} is totally reflected on the interface between the light-emitting portion 4 and the seal layer 8 toward the second surface 3B of the light-emitting layer 2.

### (1-2) Interface between light-emitting layer and air (first surface of light-emitting layer)

Light beam 10a which is emitted from the light-emitting portion 4 to enter the seal layer 8 and whose incident angle is θ_{y2} smaller than critical angle θ_{c2} at the first surface 3A of the light-emitting layer 2 passes through the first surface 3A of the light-emitting layer 2 to be emitted outside.

Meanwhile, light beam 10d whose incident angle is critical angle θ_{c} or θₓ₂ greater than critical angle θ_{c} is totally reflected on the first surface of the light-emitting layer 2 toward the second surface 3B of the light-emitting layer 2.

### (2-1) Interface between light-emitting layer and interference layer (second surface of light-emitting layer)

Among light beams 10b, 10c, 10d and 10e which travel toward the second surface 3B of the light-emitting layer 2, light beam 10b, which is virtually perpendicular to the interference layer 5, is reflected on the second surface 3B of the light-emitting layer 2 in the opposite direction (toward the front surface of the light-emitting device 1), and passes through the interface between the light-emitting portion 4 and the seal layer 8, and then the first surface 3A to be emitted outside similar to the case of light beam 10a.

Meanwhile, light beams 10c, 10d and 10e, which travel toward the interference layer 5 at inclined incident angles, pass through the interference layer 5 to travel toward the fine concavo-convex pattern 7.

### (2-2) Interface between intermediate layer and fine concavo-convex pattern

Light beams 10c, 10d and 10e, which travel toward the fine concavo-convex pattern 7, are reflected on the fine concavo-convex pattern 7 toward the second surface 3B of the light-emitting layer 2, and pass through the interference layer 5, the light-emitting portion 4 and the seal layer 8 to be emitted outside from the first surface 3A of the light-emitting layer 2 similar to the case of light beams 10a and 10e.

As described above, since all the light beams 10a to 10e, which are emitted from the light-emitting layer 2, are emitted outside from the first surface 3A of the light-emitting layer 2, the light-emitting device 1 of the present invention is improved in light-extraction efficiency. Also, light beam 10b is reflected on the interference layer 5 toward the front surface of the light-emitting device 1 and thus, the brightness of the front surface is improved. Further, the light-emitting device having a plurality of light-emitting portions 4 is improved in color purity between the light-emitting portions.

### < Other members >

Other members are not particularly limited and may be appropriately selected depending on the purpose. Examples thereof include a substrate and a protective layer.

### « Substrate »

The substrate may be appropriately selected depending on the purpose without particular limitation, and is preferably those which do not diffuse or damp light emitted from an organic compound layer. Examples of the materials for the substrate include inorganic materials such as yttria-stabilized zirconia (YSZ) and glass; and organic materials such as polyesters (e.g., polyethylene terephthalate, polybutylene phthalate and polyethylene naphthalate), polystyrene, polycarbonate, polyether sulfone, polyarylate, polyimide, polycycloolefin, norbornene resins and poly(chlorotrifluoroethylene).

For example, when the substrate is made of glass, the glass is preferably alkali-free glass in order to reduce ions eluted from it. Also, when soda-lime glass is used for the material of the substrate, a barrier coat of silica, etc., is preferably provided on the substrate. The organic materials are preferably used since they are excellent in heat resistance, dimensional stability, solvent resistance, electrical insulation and processability.

The shape, structure, size, etc. of the substrate are not particularly limited and may be appropriately selected depending on, for example, the application/purpose of the formed light-emitting device. In general, the shape thereof is preferably a sheet shape. The substrate may have a single- or multi-layered structure, and may be a single member or a combination of two or more members.

The substrate may be colorless or colored transparent. It is preferably colorless transparent, since such colorless transparent substrate does not diffuse or damp light emitted from an organic light-emitting layer.

The substrate may be provided with a moisture permeation-preventing layer (gas barrier layer) on the front or back surface thereof.

The moisture permeation-preventing layer (gas barrier layer) is preferably made from an inorganic compound such as silicon nitride and silicon oxide, and may be formed through, for example, high-frequency sputtering.

When a thermoplastic substrate is used, a hard coat layer, an under coat layer and other layers may be additionally provided as necessary.

### « Protective layer »

The light-emitting device of the present invention may be entirely protected with a protective layer.

The material contained in the protective layer may be any materials, so long as they have the function of preventing permeation of water, oxygen, etc., which promote degradation of the device.

Specific examples thereof include metals such as In, Sn, Pb, Au, Cu, Ag, Al, Ti and Ni; metal oxides such as MgO, SiO, SiO₂, Al₂O₃, GeO, NiO, CaO, BaO, Fe₂O₃, Y₂O₃ and TiO₂; metal nitrides such as SiNₓ and SiNₓO_{y}; metal fluorides such as MgF₂, LiF, AlF₃ and CaF₂; polyethylenes, polypropylenes, polymethyl methacrylates, polyimides, polyureas, polytetrafluoroethylenes, polychlorotrifluoroethylens, polydichlorofluoroethylenes, copolymers of chlorotrifluoroethylens and dichlorofluoroethylenes, copolymers produced through compolymerization of a monomer mixture containing tetrafluoroethylene and at least one comonomer, fluorine-containing copolymers containing a ring structure in the copolymerization main chain, water-absorbing materials each having a water absorption rate of 1% or more, and moisture permeation preventive substances each having a water absorption rate of 0.1% or less.

The method for forming the protective layer is not particularly limited.

Examples thereof include a vacuum deposition method, a sputtering method, a reactive sputtering method, an MBE (molecular beam epitaxial) method, a cluster ion beam method, an ion plating method, a plasma polymerization method (high-frequency excitation ion plating method), a plasma CVD method, a laser CVD method, a thermal CVD method, a gas source CVD method, a coating method, a printing method and a transfer method.

### (Display, etc.)

A display of the present invention is not particularly limited, so long as it has a plurality of light-emitting portions, and may be appropriately selected depending on the purpose.

FIG. 2 exemplarily shows a light-emitting device 11 of the present invention which has a plurality of light-emitting portions 14, and a display 50 containing the light-emitting device. This display contains the light-emitting device 11 which includes a light-emitting layer 12 containing the light-emitting portions 14; an interference layer 15; and a fine concavo-convex pattern in this order. The interference layer is disposed over a second surface 13B of the light-emitting layer 12 which surface is opposite to a first surface 13A, and reflects light emitted from the light-emitting layer 12 toward the first surface 13A. The fine concavo-convex pattern 17 reflects light emitted from the light-emitting layer 12 and has a cross-sectional shape which has portions projected and recessed with respect to the light-emitting layer. The light-emitting device 11 can be used as the display 50.

Also, an intermediate layer 16 is provided between the interference layer 15 of the light-emitting layer 11 and the fine concavo-convex pattern 17 thereof.

Notably, reference numerals 21 and 22 denote a protective layer and a substrate, respectively.

As a method for forming a full color-type display, there are known, for example, as described in "Monthly Display," September 2000, pp. 33 to 37, a tricolor light emission method by arranging, on a substrate, organic EL devices emitting lights corresponding to three primary colors (blue color (B), green color (G) and red color (R)); a white color method by separating white light emitted from an organic EL device for white color emission into three primary colors through a color filter; and a color conversion method by converting a blue light emitted from an organic EL device for blue light emission into red color (R) and green color (G) through a fluorescent dye layer.

Further, by combining a plurality of organic EL devices emitting lights of different colors which are obtained by the above-described methods, plane-type light sources emitting lights of desired colors can be obtained. For example, there are exemplified white light-emitting sources obtained by combining blue and yellow light emitting devices, and white light-emitting sources obtained by combining blue, green and red light light-emitting devices.

One exemplary light-emitting portion is an organic EL device, which will next be described in detail. However, the light-emitting device is not limited to the organic EL device and may be, for example, an inorganic EL device, an LED and a photodiode.

### < Organic EL layer >

The organic EL layer includes a substrate, a cathode, an anode and an organic compound layer including an organic light-emitting layer, wherein the cathode and the anode are laid over the substrate, and the organic light-emitting layer is sandwiched between the cathode and the anode. In terms of the function of a light-emitting device, at least one of the anode and the cathode is preferably transparent.

As a lamination pattern of the organic compound layer, preferably, a hole-transport layer, an organic light-emitting layer and an electron transport layer are laminated in this order from the anode side. Moreover, a hole-injection layer is provided between the hole-transport layer and the cathode, and/or an electron-transportable intermediate layer is provided between the organic light-emitting layer and the electron transport layer. Also, a hole-transportable intermediate layer may be provided between the organic light-emitting layer and the hole-transport layer. Similarly, an electron-injection layer may be provided between the cathode and the electron-transport layer.

Notably, each layer may be composed of a plurality of secondary layers.

The organic light-emitting layer corresponds to a light-emitting layer. Also, a transparent layer(s) of the anode, cathode, and organic compound layers (i.e., a layer(s) having optical transparency) correspond(s) to a light-transmitting layer.

Each of the constituent layers of the organic compound layer can be suitably formed in accordance with any of a dry film-forming method (e.g., a vapor deposition method and a sputtering method); a transfer method; a printing method; an ink-jet method; and a spray method.

### « Anode »

In general, the anode may be any material, so long as it has the function of serving as an electrode which supplies holes to the organic compound layer. The shape, structure, size, etc. thereof are not particularly limited and may be appropriately selected from known electrode materials depending on the application/purpose of the light-emitting device. As described above, the anode is generally provided as a transparent anode.

Preferred examples of the materials for the anode include metals, alloys, metal oxides, conductive compounds and mixtures thereof. Specific examples include conductive metal oxides such as tin oxides doped with, for example, antimony and fluorine (ATO and FTO); tin oxide, zinc oxide, indium oxide, indium tin oxide (ITO) and indium zinc oxide (IZO); metals such as gold, silver, chromium and nickel; mixtures or laminates of these metals and the conductive metal oxides; inorganic conductive materials such as copper iodide and copper sulfide; organic conductive materials such as polyaniline, polythiophene and polypyrrole; and laminates of these materials and ITO. Among them, conductive metal oxides are preferred. In particular, ITO is preferred from the viewpoints of productivity, high conductivity, transparency, etc.

The anode may be formed on the substrate by a method which is appropriately selected from wet methods such as printing methods and coating methods; physical methods such as vacuum deposition methods, sputtering methods and ion plating method; and chemical methods such as CVD and plasma CVD methods, in consideration of suitability for the material for the anode. For example, when ITO is used as a material for the anode, the anode may be formed in accordance with a DC or high-frequency sputtering method, a vacuum deposition method, or an ion plating method.

In the organic EL layer, a position at which the anode is to be formed is not particularly limited and may be appropriately determined depending on the application/purpose of the light-emitting device. Preferably, the anode is formed on the substrate. In this case, the anode may be entirely or partially formed on one surface of the substrate.

Patterning for forming the anode may be performed by a chemical etching method such as photolithography; a physical etching method such as etching by laser; a method of vacuum deposition or sputtering using a mask; a lift-off method; or a printing method.

The thickness of the anode may be appropriately selected depending on the material for the anode and is, therefore, not definitely determined. It is generally about 10 nm to about 50 µm, preferably 50 nm to 20 µm.

The resistance of the anode is preferably 10³ Ω/square or less, more preferably 10² Ω/square or less. When the anode is transparent, it may be colorless or colored. For extracting luminescence from the transparent anode side, it is preferred that the anode has a light transmittance of 60% or higher, more preferably 70% or higher.

Concerning transparent anodes, there is a detail description in "TOUMEI DOUDEN-MAKU NO SHINTENKAI (Novel Developments in Transparent Electrode Films)" edited by Yutaka Sawada, published by C.M.C. in 1999, the contents of which can be applied to the present invention. When a plastic substrate having a low heat resistance is used, it is preferred that ITO or IZO is used to form a transparent anode at a low temperature of 150° C or lower.

### « Cathode »

In general, the cathode may be any material so long as it has the function of serving as an electrode which injects electrons into the organic compound layer. The shape, structure, size, etc. thereof are not particularly limited and may be appropriately selected from known electrode materials depending on the application/purpose of the light-emitting device.

Examples of the materials for the cathode include metals, alloys, metal oxides, conductive compounds and mixtures thereof. Specific examples thereof include alkali metals (e.g., Li, Na, K and Cs), alkaline earth metals (e.g., Mg and Ca), gold, silver, lead, aluminum, sodium-potassium alloys, lithium-aluminum alloys, magnesium-silver alloys and rare earth metals (e.g., indium and ytterbium). These may be used individually, but it is preferred that two or more of them are used in combination from the viewpoint of satisfying both stability and electron-injection property.

Among them, as the materials for forming the cathode, alkali metals or alkaline earth metals are preferred in terms of excellent electron-injection property, and materials containing aluminum as a major component are preferred in terms of excellent storage stability.

The term "material containing aluminum as a major component" refers to a material composed of aluminum alone; alloys containing aluminum and 0.01% by mass to 10% by mass of an alkali or alkaline earth metal; or the mixtures thereof (e.g., lithium-aluminum alloys and magnesium-aluminum alloys).

The materials for the cathode are described in detail in JP-A Nos. 02-15595 and 05-121172. The materials described in these literatures can be used in the present invention.

The method for forming the cathode is not particularly limited, and the cathode may be formed by a known method. For example, the cathode may be formed by a method which is appropriately selected from wet methods such as printing methods and coating methods; physical methods such as vacuum deposition methods, sputtering methods and ion plating methods; and chemical methods such as CVD and plasma CVD methods, in consideration of suitability for the material for the cathode. For example, when a metal (or metals) is (are) selected as a material (or materials) for the cathode, one or more of them may be applied simultaneously or sequentially by a sputtering method.

Patterning for forming the cathode may be performed by a chemical etching method such as photolithography; a physical etching method such as etching by laser; a method of vacuum deposition or sputtering using a mask; a lift-off method; or a printing method.

In the organic EL layer, a position at which the cathode is to be formed is not particularly limited, and the cathode may be entirely or partially formed on the organic compound layer.

Furthermore, a dielectric layer having a thickness of 0.1 nm to 5 nm and being made, for example, of fluorides and oxides of an alkali or alkaline earth metal may be inserted between the cathode and the organic compound layer. The dielectric layer may be considered to be a kind of electron-injection layer. The dielectric layer may be formed by, for example, a vacuum deposition method, a sputtering method and an ion plating method.

The thickness of the cathode may be appropriately selected depending on the material for the cathode and is, therefore, not definitely determined. It is generally about 10 nm to about 5 µm, and preferably 50 nm to 1 µm.

Moreover, the cathode may be transparent or opaque. The transparent cathode may be formed as follows. Specifically, a 1 nm- to 10 nm-thick thin film is formed from a material for the cathode, and a transparent conductive material (e.g., ITO and IZO) is laminated on the thus-formed film.

### « Organic compound layer »

The organic EL device of the present invention includes at least one organic compound layer including an organic light-emitting layer. Examples of the other organic compound layers than the organic light-emitting layer include a hole-transport layer, an electron transport layer, a hole blocking layer, an electron blocking layer, a hole-injection layer and an electron injection layer.

In the organic EL device, the respective layers constituting the organic compound layer can be suitably formed by any of a dry film-forming method such as a vapor deposition method and a sputtering method; a wet film-forming method; a transfer method; a printing method; and an ink-jet method.

### <<< Organic light-emitting layer >>>

The organic light-emitting layer is a layer having the functions of receiving holes from the anode, the hole-injection layer, or the hole-transport layer, and receiving electrons from the cathode, the electron-injection layer, or the electron transport layer, and providing a field for recombination of the holes with the electrons for light emission, when an electric field is applied.

The light-emitting layer in the present invention may be composed only of a light-emitting material, or may be a layer formed form a mixture of a light-emitting dopant and a host material. The light-emitting dopant may be a fluorescent or phosphorescent light-emitting material, and may contain two or more species. The host material is preferably a charge-transporting material. The host material may contain one or more species, and, for example, is a mixture of a hole-transporting host material and an electron-transporting host material. Further, a material which does not emit light nor transport any charge may be contained in the organic light-emitting layer.

The organic light-emitting layer may be a single layer or two or more layers. When it is two or more layers, the layers may emit lights of different colors.

The above light-emitting dopant may be, for example, a phosphorescent light-emitting material (phosphorescent light-emitting dopant) and a fluorescent light-emitting material (fluorescent light-emitting dopant).

The organic light-emitting layer may contain two or more different light-emitting dopants for improving color purity and/or expanding the wavelength region of light emitted therefrom. From the viewpoint of drive durability, it is preferred that the light-emitting dopant is those satisfying the following relation(s) with respect to the above-described host compound: i.e., 1.2 eV > difference in ionization potential (ΔIp) > 0.2 eV and/or 1.2 eV > difference in electron affinity (ΔEa) > 0.2 eV.

The fluorescent light-emitting material is not particularly limited and may be appropriately selected depending on the purpose. Examples thereof include complexes containing a transition metal atom or a lanthanoid atom.

The transition metal atom is not particularly limited and may be selected depending on the purpose. Preferred are ruthenium, rhodium, palladium, tungsten, rhenium, osmium, iridium gold, silver, copper and platinum. More preferred are rhenium, iridium and platinum. Particularly preferred are iridium and platinum.

The lanthanoid atom is not particularly limited and may be appropriately selected depending on the purpose. Examples thereof include lanthanum, cerium, praseodymium, neodymium, samarium, europium, gadolinium, terbium, dysprosium, holmium, erbium, thulium, ytterbium and lutetium, with neodymium, europium and gadolinium being preferred.

Examples of ligands in the complex include those described in, for example, "Comprehensive Coordination Chemistry" authored by G. Wilkinson et al., published by Pergamon Press Company in 1987; "Photochemistry and Photophysics of Coordination Compounds" authored by H. Yersin, published by Springer-Verlag Company in 1987; and "YUHKI KINZOKU KAGAKU-KISO TO OUYOU-(Metalorganic Chemistry-Fundamental and Application-)" authored by Akio Yamamoto, published by Shokabo Publishing Co., Ltd. in 1982.

Preferred examples of the ligands include halogen ligands (preferably, chlorine ligand), aromatic carbon ring ligands (preferably 5 to 30 carbon atoms, more preferably 6 to 30 carbon atoms, still more preferably 6 to 20 carbon atoms, particularly preferably 6 to 12 carbon atoms, such as cyclopentadienyl anion, benzene anion and naphthyl anion); nitrogen-containing hetero cyclic ligands (preferably 5 to 30 atoms, more preferably 6 to 30 carbon atoms, still more preferably 6 to 20 carbon atoms, particularly preferably 6 to 12 carbon atoms, such as phenyl pyridine, benzoquinoline, quinolinol, bipyridyl and phenanthrorine), diketone ligands (e.g., acetyl acetone), carboxylic acid ligands (preferably 2 to 30 carbon atoms, more preferably 2 to 20 carbon atoms, still more preferably 2 to 16 carbon atoms, such as acetic acid ligand), alcoholate ligands (preferably 1 to 30 carbon atoms, more preferably 1 to 20 carbon atoms, still more preferably 6 to 20 carbon atoms, such as phenolate ligand), silyloxy ligands (preferably 3 to 40 carbon atoms, more preferably 3 to 30 carbon atoms, still more preferably 3 to 20 carbon atoms, such as trimethyl silyloxy ligand, dimethyl tert-butyl silyloxy ligand and triphenyl silyloxy ligand), carbon monoxide ligand; isonitrile ligand, cyano ligand, phosphorus ligand (preferably 3 to 40 carbon atoms, more preferably 3 to 30 carbon atoms, still more preferably 3 to 20 carbon atoms, particularly preferably, 6 to 20 carbon atoms, such as triphenyl phosphine ligand), thiolate ligands (preferably 1 to 30 carbon atoms, more preferably 1 to 20 carbon atoms, still more preferably 6 to 20 carbon atoms, such as phenyl thiolate ligand) and phosphine oxide ligands (preferably 3 to 30 carbon atoms, more preferably 8 to 30 carbon atoms, particularly preferably 18 to 30 carbon atoms, such as triphenyl phosphine oxide ligand), with nitrogen-containing hetero cyclic ligand being more preferred.

The above-described complexes may be a complex containing one transition metal atom in the compound, or a so-called polynuclear complex containing two or more transition metal atoms. In the latter case, the complexes may contain different metal atoms at the same time.

Among them, specific examples of the light-emitting dopants include phosphorescence luminescent compounds described in Patent Literatures such as US6303238B1, US6097147, WO00/57676, WO00/70655, WO01/08230, WO01/39234A2, WO01/41512A1, WO02/02714A2, WO02/15645A1, WO02/44189A1, WO05/19373A2, JP-A Nos. 2001-247859, 2002-302671, 2002-117978, 2003-133074, 2002-235076, 2003-123982 and 2002-170684, EP1211257, JP-A Nos. 2002-226495, 2002-234894, 2001-247859, 2001-298470, 2002-173674, 2002-203678, 2002-203679, 2004-357791, 2006-256999, 2007-19462, 2007-84635 and 2007-96259. Among them, Ir complexes, Pt complexes, Cu complexes, Re complexes, W complexes, Rh complexes, Ru complexes, Pd complexes, Os complexes, Eu complexes, Tb complexes, Gd complexes, Dy complexes and Ce complexes are preferred, with Ir complexes, Pt complexes and Re complexes being more preferred. Among them, Ir complexes, Pt complexes, and Re complexes each containing at least one coordination mode of metal-carbon bonds, metal-nitrogen bonds, metal-oxygen bonds and metal-sulfur bonds are still more preferred. Furthermore, Ir complexes, Pt complexes, and Re complexes each containing a tri-dentate or higher poly-dentate ligand are particularly preferred from the viewpoints of, for example, light-emission efficiency, drive durability and color purity. For example, tris(2-phenylpyridine)iridium (Ir(ppy)₃) can be used.

The fluorescence luminescent dopant is not particularly limited and may be appropriately selected depending on the purpose. Examples thereof include benzoxazole, benzoimidazole, benzothiazole, styrylbenzene, polyphenyl, diphenylbutadiene, tetraphenylbutadiene, naphthalimide, coumarin, pyran, perinone, oxadiazole, aldazine, pyralidine, cyclopentadiene, bis-styrylanthracene, quinacridone, pyrrolopyridine, thiadiazolopyridine, cyclopentadiene, styrylamine, aromatic dimethylidene compounds, condensed polyaromatic compounds (e.g., anthracene, phenanthroline, pyrene, perylene, rubrene and pentacene), various metal complexes (e.g., metal complexes of 8-quinolynol, pyromethene complexes and rare-earth complexes), polymer compounds (e.g., polythiophene, polyphenylene and polyphenylenevinylene), organic silanes and derivatives thereof.

Specific examples of the luminescent dopants include the following compounds, which should be construed as limiting the present invention thereto.

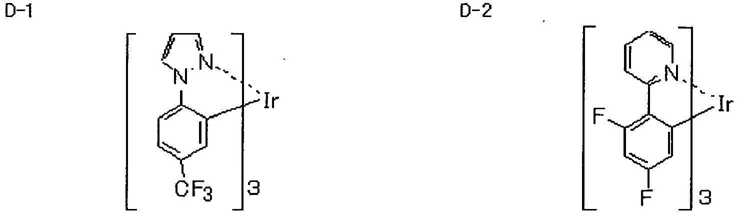

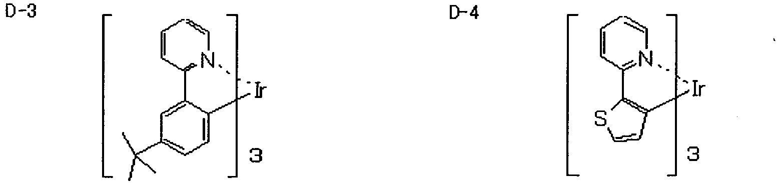

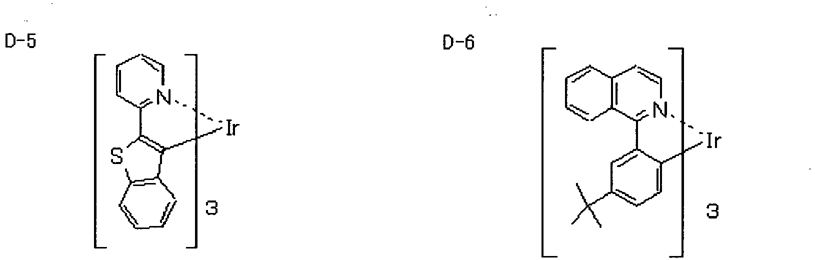

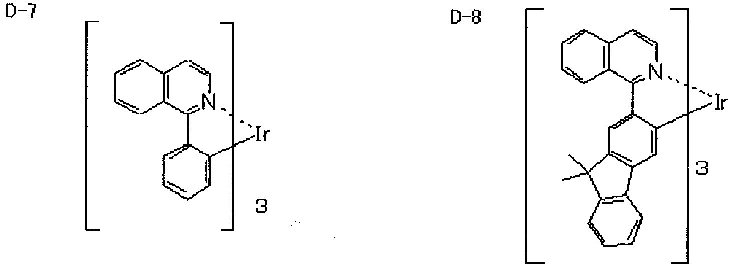

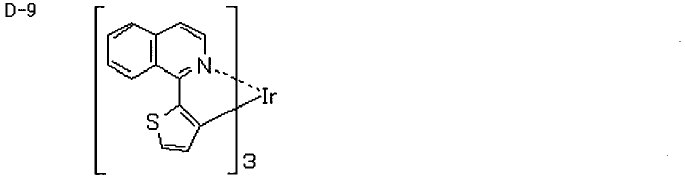

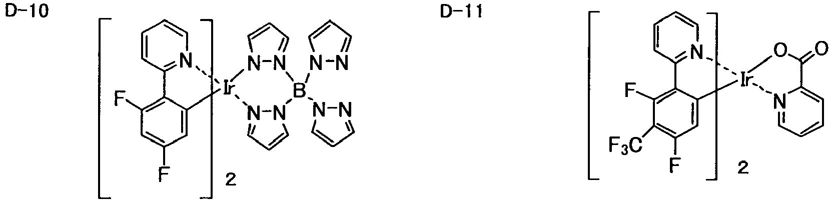

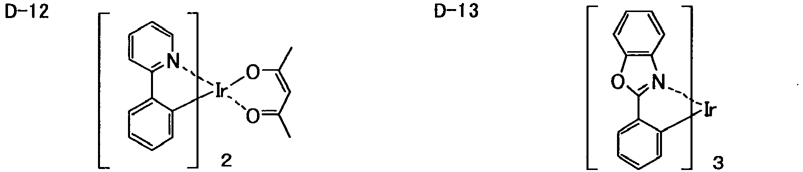

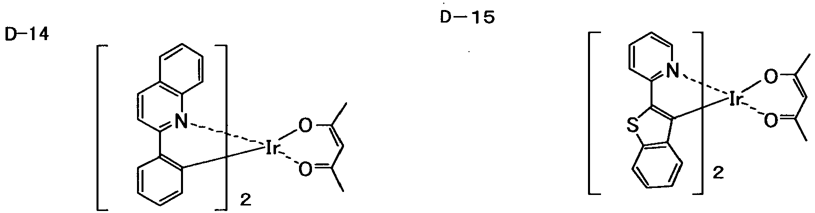

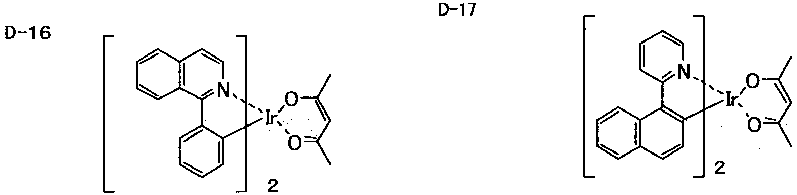

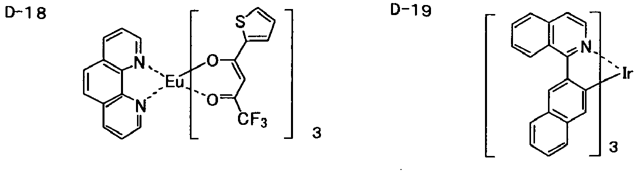

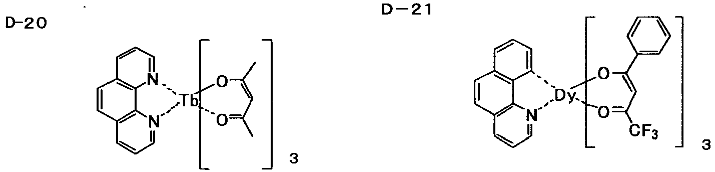

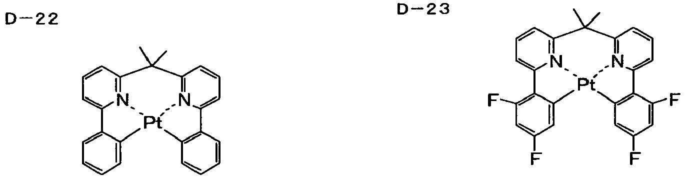

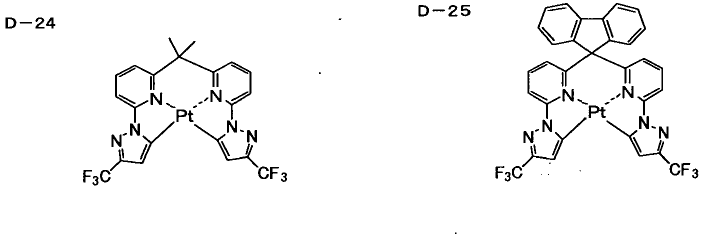

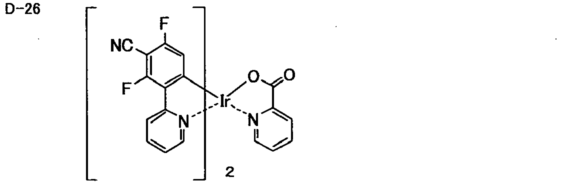

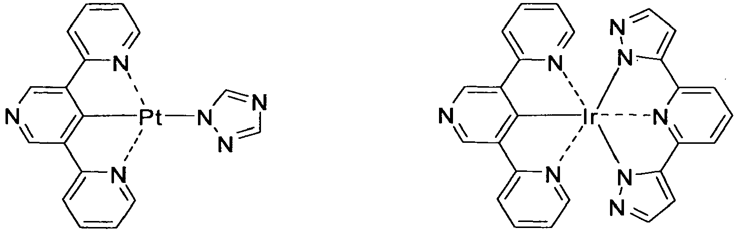

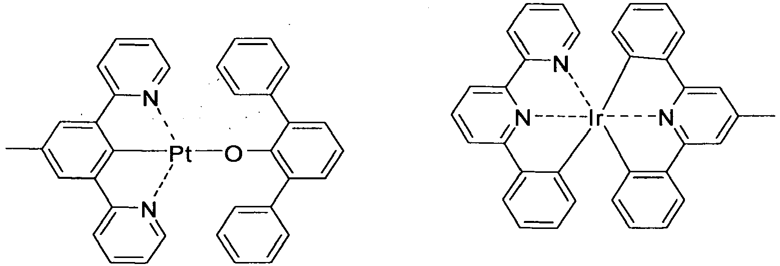

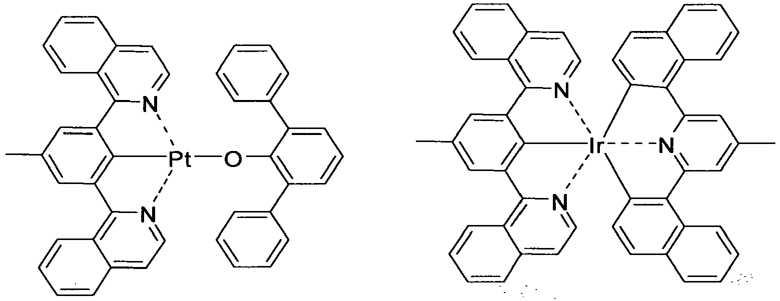

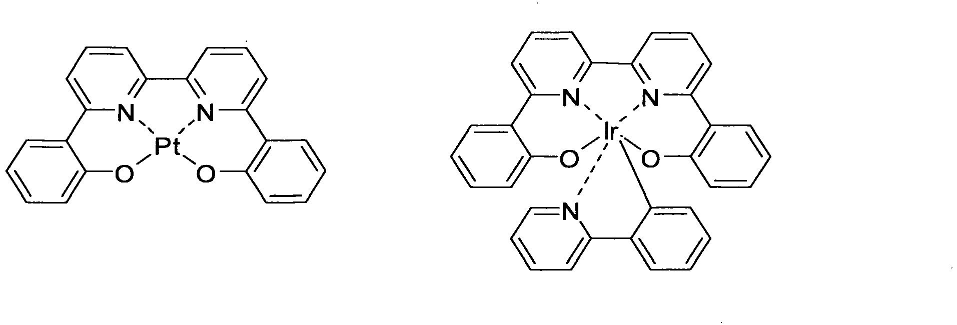

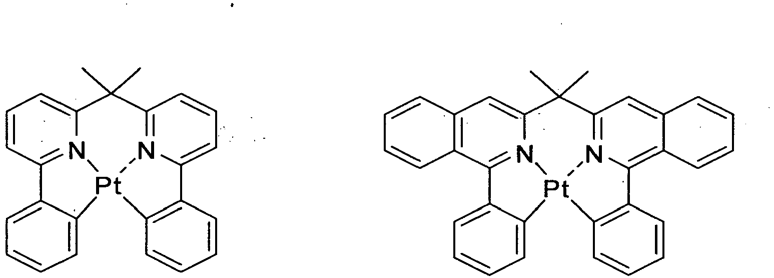

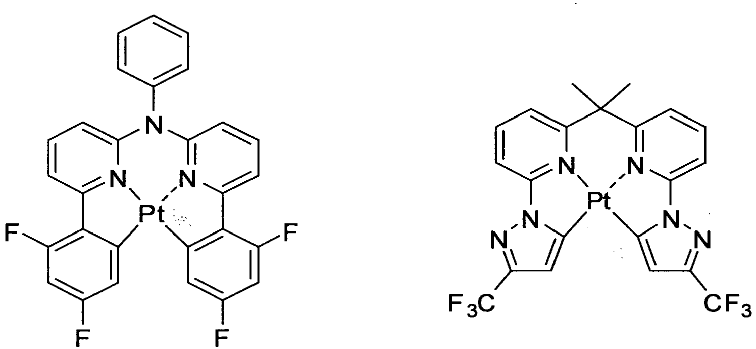

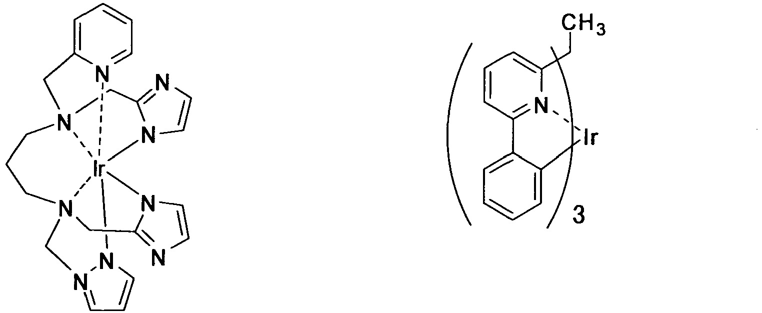

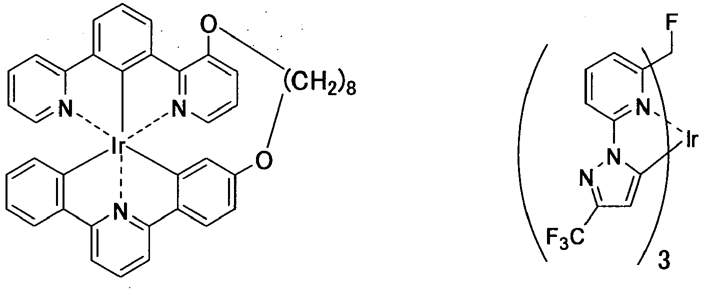

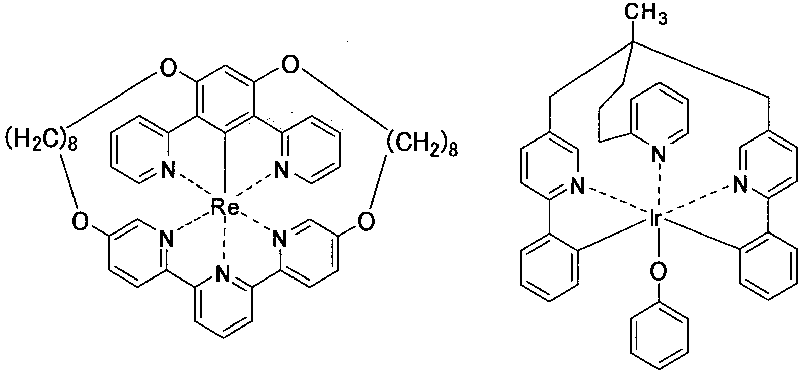

The light-emitting dopant is contained in the light-emitting layer in an amount of 0.1% by mass to 50% by mass with respect to the total amount of the compounds generally forming the light-emitting layer. From the viewpoints of drive durability and external light-emitting efficiency, it is preferably contained in an amount of 1% by mass to 50% by mass, more preferably 2% by mass to 40% by mass.

Although the thickness of the light-emitting layer is not particularly limited, in general, it is preferably 2 nm to 500 nm preferred. From the viewpoint of external light-emitting efficiency, it is more preferably 3 nm to 200 nm, particularly preferably 5 nm to 100 nm.

The host material may be hole transporting host materials excellent in hole transporting property (which may be referred to as a "hole transporting host") or electron transporting host compounds excellent in electron transporting property (which may be referred to as an "electron transporting host").

Examples of the hole transporting host materials contained in the organic light-emitting layer include pyrrole, indole, carbazole, azaindole, azacarbazole, triazole, oxazole, oxadiazole, pyrazole, imidazole, thiophene, polyarylalkane, pyrazoline, pyrazolone, phenylenediamine, arylamine, amino-substituted chalcone, styrylanthracene, fluorenone, hydrazone, stilbene, silazane, aromatic tertiary amine compounds, styrylamine compounds, aromatic dimethylidine compounds, porphyrin compounds, polysilane compounds, poly(N-vinylcarbazole), aniline copolymers, conducive high-molecular-weight oligomers (e.g., thiophene oligomers and polythiophenes), organic silanes, carbon films and derivatives thereof. For example, 1,3-bis(carbazol-9-yl) benzene (mCP) can be used.

Among them, indole derivatives, carbazole derivatives, aromatic tertiary amine compounds and thiophene derivatives are preferred. Also, compounds each containing a carbazole group in the molecule are more preferred. Further, compounds each containing a t-butyl-substituted carbazole group are particularly preferred.

The electron transporting host to be used in the organic light-emitting layer preferably has an electron affinity Ea of 2.5 eV to 3.5 eV, more preferably 2.6 eV to 3.4 eV, particularly preferably 2.8 eV to 3.3 eV, from the viewpoints of improvement in durability and decrease in drive voltage. Also, it preferably has an ionization potential Ip of 5.7 eV to 7.5 eV, more preferably 5.8 eV to 7.0 eV, particularly preferably 5.9 eV to 6.5 eV, from the viewpoints of improvement in durability and decrease in drive voltage.

Examples of the electron transporting host include pyridine, pyrimidine, triazine, imidazole, pyrazole, triazole, oxazole, oxadiazole, fluorenone, anthraquinonedimethane, anthrone, diphenylquinone, thiopyrandioxide, carbodiimide, fluorenylidenemethane, distyrylpyradine, fluorine-substituted aromatic compounds, heterocyclic tetracarboxylic anhydrides (e.g., naphthalene and perylene), phthalocyanine, derivatives thereof (which may form a condensed ring with another ring) and various metal complexes such as metal complexes of 8-quinolynol derivatives, metal phthalocyanine, and metal complexes having benzoxazole or benzothiazole as a ligand.

Preferred electron transporting hosts are metal complexes, azole derivatives (e.g., benzimidazole derivatives and imidazopyridine derivatives) and azine derivatives (e.g., pyridine derivatives, pyrimidine derivatives and triazine derivatives). Among them, metal complexes are preferred in terms of durability. As the metal complexes (A), preferred are those containing a ligand which has at least one nitrogen atom, oxygen atom, or sulfur atom and which is coordinated with the metal.

The metal ion contained in the metal complex is not particularly limited and may be appropriately selected depending on the purpose. It is preferably a beryllium ion, a magnesium ion, an aluminum ion, a gallium ion, a zinc ion, an indium ion, a tin ion, a platinum ion or a palladium ion; more preferably is a beryllium ion, an aluminum ion, a gallium ion, a zinc ion, a platinum ion or a palladium ion; particularly preferably is an aluminum ion, a zinc ion or a palladium ion.

Although there are a variety of known ligands to be contained in the metal complexes, examples thereof include those described in, for example, "Photochemistry and Photophysics of Coordination Compounds" authored by H. Yersin, published by Springer-Verlag Company in 1987; and "YUHKI KINZOKU KAGAKU-KISO TO OUYOU-(Metalorganic Chemistry-Fundamental and Application-)" authored by Akio Yamamoto, published by Shokabo Publishing Co., Ltd. in 1982.

The ligand is preferably nitrogen-containing heterocyclic ligands (preferably having 1 to 30 carbon atoms, more preferably 2 to 20 carbon atoms, particularly preferably 3 to 15 carbon atoms). It may be a unidentate ligand or a bi- or higher-dentate ligand. Preferred are bi- to hexa-dentate ligands, and mixed ligands of bi- to hexa-dentate ligands with a unidentate ligand.

Examples of the ligand include azine ligands (e.g., pyridine ligands, bipyridyl ligands and terpyridine ligands); hydroxyphenylazole ligands (e.g., hydroxyphenylbenzoimidazole ligands, hydroxyphenylbenzoxazole ligands, hydroxyphenylimidazole ligands and hydroxyphenylimidazopyridine ligands alkoxy ligands (those having preferably 1 to 30 carbon atoms, more preferably 1 to 20 carbon atoms, particularly preferably 1 to 10 carbon atoms, such as methoxy, ethoxy, butoxy and 2-ethylhexyloxy); and aryloxy ligands (those having preferably 6 to 30 carbon atoms, more preferably 6 to 20 carbon atoms, particularly preferably 6 to 12 carbon atoms, such as phenyloxy, 1-naphthyloxy, 2-naphthyloxy, 2,4,6-trimethylphenyloxy and 4-biphenyloxy).

Further examples include heteroaryloxy ligands (those having preferably 1 to 30 carbon atoms, more preferably 1 to 20 carbon atoms, particularly preferably 1 to 12 carbon atoms, examples of which include pyridyloxy, pyrazyloxy, pyrimidyloxy and quinolyloxy); alkylthio ligands (those having preferably 1 to 30 carbon atoms, more preferably 1 to 20 carbon atoms, particularly preferably 1 to 12 carbon atoms, examples of which include methylthio and ethylthio); arylthio ligands (those having preferably 6 to 30 carbon atoms, more preferably 6 to 20 carbon atoms, particularly preferably 6 to 12 carbon atoms, examples of which include phenylthio); heteroarylthio ligands (those having preferably 1 to 30 carbon atoms, more preferably 1 to 20 carbon atoms, particularly preferably 1 to 12 carbon atoms, examples of which include pyridylthio, 2-benzimidazolylthio, 2-benzoxazolylthio and 2-benzothiazolylthio); siloxy ligands (those having preferably 1 to 30 carbon atoms, more preferably 3 to 25 carbon atoms, particularly preferably 6 to 20 carbon atoms, examples of which include a triphenylsiloxy group, a triethoxysiloxy group and a triisopropylsiloxy group); aromatic hydrocarbon anion ligands (those having preferably 6 to 30 carbon atoms, more preferably 6 to 25 carbon atoms, particularly preferably 6 to 20 carbon atoms, examples of which include a phenyl anion, a naphthyl anion and an anthranyl anion); aromatic heterocyclic anion ligands (those having preferably 1 to 30 carbon atoms, more preferably 2 to 25 carbon atoms, and particularly preferably 2 to 20 carbon atoms, examples of which include a pyrrole anion, a pyrazole anion, a triazole anion, an oxazole anion, a benzoxazole anion, a thiazole anion, a benzothiazole anion, a thiophene anion and a benzothiophene anion); and indolenine anion ligands. Among them, nitrogen-containing heterocyclic ligands, aryloxy ligands, heteroaryloxy groups, siloxy ligands, etc. are preferred, and nitrogen-containing heterocyclic ligands, aryloxy ligands, siloxy ligands, aromatic hydrocarbon anion ligands, aromatic heterocyclic anion ligands, etc. are more preferred.

Examples of the metal complex electron transporting host include compounds described in, for example, JP-A Nos. 2002-235076, 2004-214179, 2004-221062, 2004-221065, 2004-221068 and 2004-327313.

In the light-emitting layer, it is preferred that the lowest triplet excitation energy (T1) of the host material is higher than T1 of the phosphorescence light-emitting material, from the viewpoints of color purity, light-emitting efficiency and drive durability.

Although the amount of the host compound added is not particularly limited, it is preferably 15% by mass to 95% by mass with respect to the total amount of the compounds forming the light-emitting layer, in terms of light emitting efficiency and drive voltage.

### « Hole-injection layer and hole-transport layer »

The hole-injection layer and hole-transport layer are layers having the function of receiving holes from the anode or from the anode side and transporting the holes to the cathode side. Materials to be incorporated into the hole-injection layer or the hole-transport layer may be a low-molecular-weight compound or a high-molecular-weight compound.

Specifically, these layers preferably contain, for example, pyrrole derivatives, carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidine compounds, phthalocyanine compounds, porphyrin compounds, thiophene derivatives, organosilane derivatives and carbon.

Also, an electron-accepting dopant may be incorporated into the hole-injection layer or the hole-transport layer of the organic EL device. The electron-accepting dopant may be, for example, an inorganic or organic compound, so long as it has electron accepting property and the function of oxidizing an organic compound.

Specific examples of the inorganic compound include metal halides (e.g., ferric chloride, aluminum chloride, gallium chloride, indium chloride and antimony pentachloride) and metal oxides (e.g., vanadium pentaoxide and molybdenum trioxide).

As the organic compounds, those having a substituent such as a nitro group, a halogen, a cyano group and a trifluoromethyl group; quinone compounds; acid anhydride compounds; and fullerenes may be preferably used.

In addition, there can be preferably used compounds described in, for example, JP-A Nos. 06-212153, 11-111463, 11-251067, 2000-196140, 2000-286054, 2000-315580, 2001-102175, 2001-160493, 2002-252085, 2002-56985, 2003-157981, 2003-217862, 2003-229278, 2004-342614, 2005-72012, 2005-166637 and 2005-209643.

Among them, preferred are hexacyanobutadiene, hexacyanobenzene, tetracyanoethylene, tetracyanoquinodimethane, tetrafluorotetracyanoquinodimethane (F4-TCNQ), p-fluoranil, p-chloranil, p-bromanil, p-benzoquinone, 2,6-dichlorobenzoquinone, 2,5-dichlorobenzoquinone, 1,2,4,5-tetracyanobenzene, 1,4-dicyanotetrafluorobenzene, 2,3-dichloro-5,6-dicyanobenzoquinone, p-dinitrobenzene, m-dinitrobenzene, o-dinitrobenzene, 1,4-naphthoquinone, 2,3-dichloronaphthoquinone, 1,3-dinitronaphthalene, 1,5-dinitronaphthalene, 9,10-anthraquinone, 1,3,6,8-tetranitrocarbazole, 2,4,7-trinitro-9-fluorenone, 2,3,5,6-tetracyanopyridine and fullerene C60. More preferred are hexacyanobutadiene, hexacyanobenzene, tetracyanoethylene, tetracyanoquinodimethane, tetrafluorotetracyanoquinodimethane, p-fluoranil, p-chloranil, p-bromanil, 2,6-dichlorobenzoquinone, 2,5-dichlorobenzoquinone, 2,3-dichloronaphthoquinone, 1,2,4,5-tetracyanobenzene, 2,3-dichloro-5,6-dicyanobenzoquinone, 4,4',4"-tris(2-naphthylphenylamino)triphenylamine (2-TNATA), N,N'-dinaphthyl-N,N'-diphenyl-[1,1'-biphenyl]-4,4'-diamine (α-NPD) and 2,3,5,6-tetracyanopyridine. Particularly preferred is tetrafluorotetracyanoquinodimethane.

These electron-accepting dopants may be used alone or in combination. Although the amount of the electron-accepting dopant used depends on the type of material, the dopant is preferably used in an amount of 0.01% by mass to 50% by mass, more preferably 0.05% by mass to 20% by mass, particularly preferably 0.1% by mass to 10% by mass, with respect to the material of the hole-transport layer.

The thicknesses of the hole-injection layer and the hole-transport layer are each preferably 500 nm or less in terms of reducing drive voltage.

The thickness of the hole-transport layer is preferably 1 nm to 500 nm, more preferably 5 nm to 200 nm, still more preferably 10 nm to 100 nm. The thickness of the hole-injection layer is preferably 0.1 nm to 200 nm, more preferably 0.5 nm to 100 nm, still more preferably 1 nm to 100 nm.

Each of the hole-injection layer and the hole-transport layer may have a single-layered structure made of one or more of the above-mentioned materials, or a multi-layered structure made of a plurality of layers which are identical or different in composition.

### <<< Electron-injection layer and electron-transport layer >>>

The electron-injection layer and the electron-transport layer are layers having the functions of receiving electrons from the cathode or the cathode side and transporting the electrons to the anode side. The electron-injection materials or electron-transport materials for these layers may be low-molecular-weight or high-molecular-weight compounds.

Specific examples thereof include pyridine derivatives, quinoline derivatives, pyrimidine derivatives, pyrazine derivatives, phthalazine derivatives, phenanthoroline derivatives, triazine derivatives, triazole derivatives, oxazole derivatives, oxadiazole derivatives, imidazole derivatives, fluorenone derivatives, anthraquinodimethane derivatives, anthrone derivatives, diphenylquinone derivatives, thiopyrandioxide derivatives, carbodiimide derivatives, fluorenylidenemethane derivatives, distyrylpyradine derivatives, aryl tetracarboxylic anhydrides such as perylene and naphthalene, phthalocyanine derivatives, metal complexes (e.g., metal complexes of 8-quinolinol derivatives, metal phthalocyanine, and metal complexes containing benzoxazole or benzothiazole as the ligand) and organic silane derivatives (e.g., silole).

The electron-injection layer or the electron-transport layer in the organic EL device of the present invention may contain an electron donating dopant. The electron donating dopant to be introduced in the electron-injection layer or the electron-transport layer may be any material, so long as it has an electron-donating property and a property for reducing an organic compound. Preferred examples thereof include alkali metals (e.g., Li), alkaline earth metals (e.g., Mg), transition metals including rare-earth metals, and reducing organic compounds. Among the metals, those having a work function of 4.2 eV or less are particularly preferably used. Examples thereof include Li, Na, K, Be, Mg, Ca, Sr, Ba, Y, Cs, La, Sm, Gd and Yb. Also, examples of the reducing organic compounds include nitrogen-containing compounds, sulfur-containing compounds and phosphorus-containing compounds.

In addition, there may be used materials described in, for example, JP-A Nos. 06-212153, 2000-196140, 2003-68468, 2003-229278 and 2004-342614.

These electron donating dopants may be used alone or in combination. The amount of the electron donating dopant used depends on the type of the material, but it is preferably 0.1% by mass to 99% by mass, more preferably 1.0% by mass to 80% by mass, particularly preferably 2.0% by mass to 70% by mass, with respect to the amount of the material of the electron transport layer.

The thicknesses of the electron-injection layer and the electron-transport layer are each preferably 500 nm or less in terms of reducing drive voltage.

The thickness of the electron-transport layer is preferably 1 nm to 500 nm, more preferably 5 nm to 200 nm, particularly preferably 10 nm to 100 nm. The thickness of the electron-injection layer is preferably 0.1 nm to 200 nm, more preferably 0.2 nm to 100 nm, particularly preferably 0.5 nm to 50 nm.

Each of the electron-injection layer and the electron-transport layer may have a single-layered structure made of one or more of the above-mentioned materials, or a multi-layered structure made of a plurality of layers which are identical or different in composition.

### <<< Hole blocking layer >>>

The hole blocking layer is a layer having the function of preventing the holes, which have been transported from the anode side to the light-emitting layer, from passing toward the cathode side, and may be provided as an organic compound layer adjacent to the light-emitting layer on the cathode side.

Examples of the compound forming the hole blocking layer include aluminum complexes (e.g., bis-(2-methyl-8-quinolinolate)-4-(phenylphenolate)aluminum (BAlq)), triazole derivatives and phenanthroline derivatives (e.g., BCP).

The thickness of the hole blocking layer is preferably 1 nm to 500 nm, more preferably 5 nm to 200 nm, particularly preferably 10 nm to 100 nm.

The hole blocking layer may have a single-layered structure made of one or more of the above-mentioned materials, or a multi-layered structure made of a plurality of layers which are identical or different in composition.

### <<< Electron blocking layer >>>

An electron blocking layer is a layer having the function of preventing the electrons, which have been transported from the cathode side to the light-emitting layer, from passing toward the anode side, and may be provided as an organic compound layer adjacent to the light-emitting layer on the anode side in the present invention.

Examples of the compound forming the electron blocking layer include those listed as a hole-transport material.

The thickness of the electron blocking layer is preferably 1 nm to 500 nm, more preferably 5 nm to 200 nm, particularly preferably 10 nm to 100 nm.

The electron blocking layer may have a single-layered structure made of one or more of the above-mentioned materials, or a multi-layered structure made of a plurality of layers which are identical or different in composition.

### « Driving »

The organic EL layer can emit light when a DC voltage (which, if necessary, contains AC components) (generally 2 volts to 15 volts) or a DC is applied to between the anode and the cathode.

For the driving method of the organic EL layer, applicable are those described in, for example, JP-A Nos. 02-148687, 06-301355, 05-29080, 07-134558, 08-234685 and 08-241047, Japanese Patent No. 2784615, and U.S. Pat. Nos. 5,828,429 and 6,023,308.

In the organic EL device, the light-extraction efficiency can be further improved by various known methods. It is possible to increase the light-extraction efficiency to improve the external quantum efficiency, for example, by processing the surface shape of the substrate (for example, by forming a fine concavo-convex pattern), by controlling the refractive index of the substrate, the ITO layer and/or the organic layer, or by controlling the thickness of the substrate, the ITO layer and/or the organic layer.

The organic EL layer may be used in a so-called top-emission configuration in which light is extracted from the anode side.

The organic EL layer may have the configuration in which charge-generation layers are provided between a plurality of light-emitting layers for the purpose of further enhancing the light-emission efficiency.

The charge-generation layer has the function of generating charges (holes and electrons) during application of an electric field as well as the function of injecting the generated charges into the adjacent layer to the charge-generation layer.

The charge-generation layer is made of any material, so long as it has the above-described functions. Also, it may be made of a single compound or a plurality of compounds.

Specifically, the material/compound may be conductive materials, semi-conductive materials (like doped organic layers) or insulating materials. Specific examples thereof include those disclosed in, for example, JP-A Nos. 11-329748, 2003-272860 and 2004-39617.

More specific examples thereof include transparent conductive materials such as ITO and indium zinc oxide (IZO); fullerenes such as C60; conductive organic compounds such as thiophene oligomers; conductive organic compounds such as metal phthalocyanines, metal-free phthalocyanines, metal porphyrins and metal-free porphyrins; metal materials such as Ca, Ag, Al, Mg-Ag alloy, Al-Li alloy and Mg-Li alloy; hole conductive materials; conductive materials; and mixtures thereof.

Examples of the hole conductive material include hole transport organic materials (e.g., 2-TNATA and NPD) doped with oxidants having electron attracting properties (e.g., F4-TCNQ, TCNQ and FeCl₃), P-type conductive polymers and P-type semiconductors. Examples of the conductive material include the electron transport organic materials doped with metals or metal compounds having a work function of less than 4.0 eV, N-type conductive polymers and N-type semiconductors. Examples of the N-type semiconductor include N-type Si, N-type CdS and N-type ZnS. Examples of the P-type semiconductor include P-type Si, P-type CdTe and P-type CuO.

Further, the charge-generation layer may use an insulating material such as V₂O₅.

The electric charge-generation layer may have a single-layered structure or be a laminate of a plurality of layers. Examples of the laminate include laminates of hole or electron conductive material and conductive materials (e.g., a transparent conductive material and a metal material); and a laminate of the hole and electron conductive materials.

In general, preferably, the film thickness or the material of the charge-generation layer can be selected so that the transmittance with respect to a visible light is 50% or more. The film thickness is not particularly limited and may be appropriately determined depending on the purpose. It is preferably 0.5 nm to 200 nm, more preferably 1 nm to 100 nm, still more preferably 3 nm to 50 nm, particularly preferably 5 nm to 30 nm.

The method for forming the charge-generation layer is not particularly limited, and the above-described method for forming the organic compound layer can also be employed.

The charge-generation layer is formed between two or more of the light-emitting layer. Also, a material having the function of injecting charges may be incorporated into the adjacent layers to the charge-generation layer on the anode and cathode sides. In order to increase injection properties of electrons into the adjacent layers on the anode side, electron-injecting compounds such as BaO, SrO, Li₂O, LiCl, LiF, MgF₂, MgO and CaF₂ may be laminated on a surface of the charge-generation layer which faces the anode.

Other than the materials described above, the material for the charge-generation layer may be selected based on the description in, for examples, JP-A No. 2003-45676 and U.S. Pat. Nos. 6337492, 6107734 and 6872472.

The organic EL layer may have a resonator structure. For example, on a transparent substrate are stacked a multi-layered film mirror composed of a plurality of laminated films having different reflective indices, a transparent or semi-transparent electrode, a light-emitting layer and a metal electrode. The light generated in the light-emitting layer is repeatedly reflected between the multi-layered film mirror and the metal electrode (which serve as reflection plates); i.e., is resonated.

In another preferred embodiment, a transparent or semi-transparent electrode and a metal electrode are stacked on a transparent substrate. In this structure, the light generated in the light-emitting layer is repeatedly reflected between the transparent or semi-transparent electrode and the metal electrode (which serve as reflection plates); i.e., is resonated.

For forming the resonance structure, an optical path length determined based on the effective refractive index of two reflection plates, and on the refractive index and the thickness of each of the layers between the reflection plates is adjusted to be an optimal value for obtaining a desired resonance wavelength. The calculation formula applied in the case of the first embodiment is described in JP-A No. 09-180883. The calculation formula in the case of the second embodiment is described in JP-A No. 2004-127795.

### Examples

The present invention will next be described by way of examples, which should not be construed as limiting the present invention thereto.

### (Example 1)

A light-emitting device of Example 1 was fabricated as follows.

### < Formation of fine concavo-convex pattern >

Through the below procedure, a fine concavo-convex pattern was formed and then provided with a reflective layer over one surface thereof.

### « Fine concavo-convex portions »

A thin film was formed on a glass substrate using compound A given below; i.e., an ionically-bonded compound of the upper and lower compounds (compound A has a high refractive index: n₅ = 1.73 with respect to light having a wavelength of 550 nm (main light-emitting wavelength)).

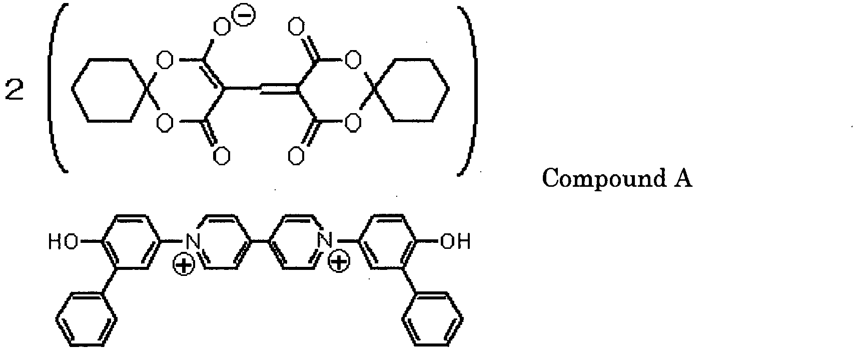

A material made of compound A (35 mg) was dissolved in tetrafluoropropanol (1 mL). The resultant solution was dropped on the glass substrate which was being rotated at 300 rpm. Then, the rotation speed was increased to 1,000 rpm, whereby a 200 nm-thick thin film was formed.

The thin film was treated using a fine processing device (NEO1000, product of Pulstec Industrial Co., Ltd.) to form a fine concavo-convex pattern having a pitch interval of 0.6λ.

### « Reflective layer »

Through DC sputtering, a 100 nm-thick Ag thin film was formed on the fine concavo-convex pattern as a reflective layer.

### < Formation of intermediate layer >

A material made of compound A (70 mg) was dissolved in tetrafluoropropanol (1 mL). The resultant solution was dropped on the fine concavo-convex pattern-formed glass substrate which was being rotated at 300 rpm. Then, the rotation speed was increased to 1,000 rpm, whereby a 400 nm-thick thin film was formed.

Here, the intermediate layer was formed so that the intermediate layer's refractive index n₅ was the same as the light-emitting portion's refractive index n₃ with respect to light having a main light-emitting wavelength.

### < Formation of interference layer >

Through RF sputtering, two interference layers each being a 55 nm-thick TiO layer were formed on the intermediate layer.

Notably, the interference layers were formed so that the optical thickness of one of the layers falls within a range of (2n₃ + 1)λ/4 ± λ/8, where λ and n₃ denote a main light-emitting wavelength and the refractive index of the light-emitting portion, respectively (hereinafter this range is referred to as a "predetermined optical thickness").

### < Formation of organic EL layer (light-emitting portion) >

An organic EL device was formed using a resistance heating vacuum deposition apparatus.

A 70 nm-thick ITO (indium tin oxide) layer was formed on the interference layer as an anode.

A 160 nm-thick hole-injection layer was formed on the ITO layer by co-evaporating 4,4',4"-tris(2-naphthylphenylamino)triphenylamine (which is abbreviated as "2-TNATA," refer to the following structural formula) and tetrafluorotetracyanoquinodimethane (which is abbreviated as "F4-TCNQ," refer to the following structural formula) so that the amount of F4-TCNQ was 1.0% by mass with respect to 2-TNATA.

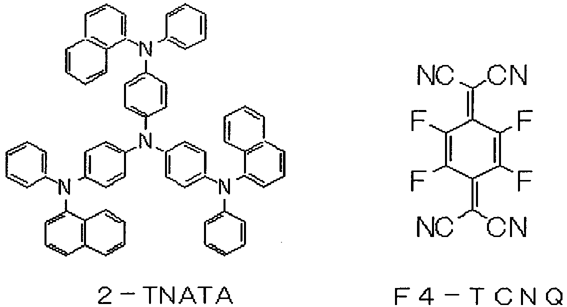

A 10 nm-thick hole-transport layer was formed on the hole injection layer using N,N'-dinaphthyl-N,N'-diphenyl-[1,1'-biphenyl]-4,4'-diamine (which is abbreviated as "α-NPD," refer to the following structural formula).

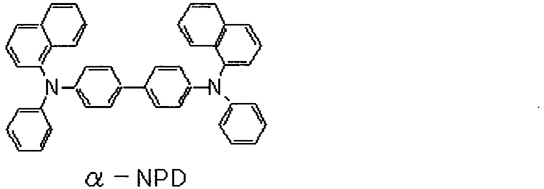

A 30 nm-thick organic light-emitting layer was formed on the hole transport layer by co-evaporating 1,3-bis(carbazol-9-yl)benzene (which is abbreviated as "mCP," refer to the following structural formula) and green light-emitting material tris(2-phenylpyridine)iridium (which is abbreviated as "Ir(ppy)₃," refer to the following structural formula) so that the amount of the green light-emitting material was 5% by mass with respect to mCP.

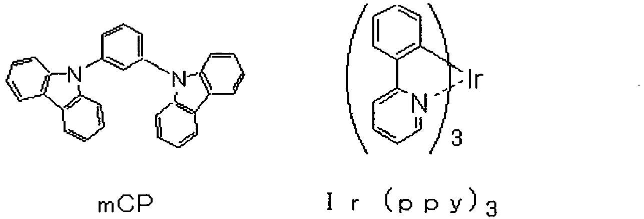

Subsequently, a 40 nm-thick electron transport layer was formed on the organic light-emitting layer using bis-(2-methyl-8-quinolinolate)-4-(phenylphenolate) aluminum (which is abbreviated as "BAlq," refer to the following structural formula).

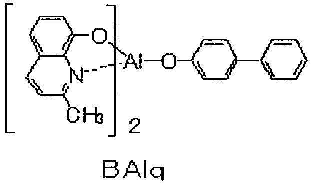

Further, patterning was performed using a shadow mask to form a 1 nm-thick LiF layer, a 2 nm-thick Al layer and a 100 nm-thick ITO layer.

### < Seal layer >

A seal layer was formed on the organic EL layer using a mixture of SiNx and SiOx. The seal layer was found to have a refractive index of about 1.8.

### (Example 2)

The procedure of Example 1 was repeated, except that three interference layers were formed, to thereby fabricate a light-emitting device of Example 2.

### (Example 3)

The procedure of Example 1 was repeated, except that five interference layers were formed, to thereby fabricate a light-emitting device of Example 3.

### (Example 4)

The procedure of Example 1 was repeated, except that 11 interference layers were formed, to thereby fabricate a light-emitting device of Example 4.

### (Example 5)

### (example not being part of the present invention)

The procedure of Example 1 was repeated, except that one interference layer was formed, to thereby fabricate a light-emitting device of Example 5.

### (Example 6)

### (example not being part of the present invention)

The procedure of Example 1 was repeated, except that 105 interference layers were formed, to thereby fabricate a light-emitting device of Example 6.

### (Example 7)

The procedure of Example 1 was repeated, except that the intermediate layer was formed so that the refractive index n₅ was the same as 0.9n₃ rather than n₃, to thereby fabricate a light-emitting device of Example 7.

### (Example 8)

The procedure of Example 1 was repeated, except that the intermediate layer was formed so that the refractive index n₅ was the same as 0.95n₃ rather than n₃, to thereby fabricate a light-emitting device of Example 8.

### (Example 9)

### (example not being part of the present invention)

The procedure of Example 1 was repeated, except that the intermediate layer was formed so that the refractive index n₅ was the same as 0.85n₃ rather than n₃, to thereby fabricate a light-emitting device of Example 9.

### (Example 10)

The procedure of Example 1 was repeated, except that a fine concavo-convex pattern was formed so that the pitch interval was 0.15λ rather than 0.6λ, to thereby fabricate a light-emitting device of Example 10.

### (Example 11)

The procedure of Example 1 was repeated, except that a fine concavo-convex pattern was formed so that the pitch interval was 0.005λ rather than 0.6λ, to thereby fabricate a light-emitting device of Example 11.

### (Example 12)

The procedure of Example 1 was repeated, except that the number of interference layers having the above predetermined optical thickness was changed from 1 to 2, to thereby fabricate a light-emitting device of Example 12.

### (Example 13)

The procedure of Example 1 was repeated, except that the number of interference layers having the above predetermined optical thickness was changed from 1 to 3, to thereby fabricate a light-emitting device of Example 13.

### (Comparative Example 1)

The procedure of Example 1 was repeated, except that no interference layer was formed and that an organic EL layer was formed on the intermediate layer, to thereby fabricate a light-emitting device of Comparative Example 1.

### (Comparative Example 2)

The procedure of Example 1 was repeated, except that no fine concavo-convex pattern was formed and that an intermediate layer was formed on a glass substrate, to thereby fabricate a light-emitting device of Comparative Example 2.

### < Measuring method >

### « Refractive index »

The refractive index of the interference layer, the organic EL layer (light-emitting portion), the intermediate layer or the seal layer was measured with an ellipsometry method.

### « Pitch interval of fine concavo-convex pattern »

The pitch interval of the fine concavo-convex pattern was measured with an AFM (product name: OLS3500, product of OLYMPUS CORPORATION).

### « Light quantity »

The light emitted from the fabricated light-emitting device was measured with a multichannel spectrometer (product of Ocean Photonics, Inc.).

Notably, the main light-emitting wavelength of the light emitted from the EL layer (light-emitting portion) was measured with a multichannel spectrometer (product of Ocean Photonics, Inc.).

### < Evaluation of light-extraction efficiency >

Each of the fabricated light-emitting devices was evaluated for light-extraction efficiency as follows.

The light-extraction efficiency was evaluated based on the ratio Q₂/Q₁, where Q₁ denotes a light quantity of a light-emitting device having no fine concavo-convex pattern (i.e., this value being regarded as 1) and Q₂ denotes a light quantity of each of the fabricated light-emitting devices of Examples 1 to 13 and Comparative Examples 1 and 2. The results are shown in Table 1.

**Table 1**

| | Number of interference layers | Pitch interval of fine pattern (xλ) | Refractive index of intermediate layer (xn₃) | Number of layers having the predetermined optical thickness | Light-extraction efficiency |
|---|---|---|---|---|---|
| Ex. 1 | 2 | 0.6 | 1.00 | 1 | 1.12 |
| Ex. 2 | 3 | 0.6 | 1.00 | 1 | 1.13 |
| Ex. 3 | 5 | 0.6 | 1.00 | 1 | 1.15 |
| Ex. 4 | 11 | 0.6 | 1.00 | 1 | 1.20 |
| X Ex. 5 | 1 | 0.6 | 1.00 | 1 | 1.10 |
| X Ex. 6 | 105 | 0.6 | 1.00 | 1 | 1.05 |
| Ex. 7 | 2 | 0.6 | 0.90 | 1 | 1.07 |
| Ex. 8 | 2 | 0.6 | 0.95 | 1 | 1.10 |
| X Ex. 9 | 2 | 0.6 | 0.85 | 1 | 1.04 |
| Ex. 10 | 2 | 0.15 | 1.00 | 1 | 1.10 |
| Ex. 11 | 2 | 0.005 | 1.00 | 1 | 1.03 |
| Ex. 12 | 2 | 0.6 | 1.00 | 2 | 1.10 |
| Ex. 13 | 2 | 0.6 | 1.00 | 3 | 1.12 |
| Comp. Ex. 1 | - | 0.6 | 1.00 | 1 | 1.03 |
| Comp. Ex. 2 | 2 | - | 1.00 | 1 | 1.00 |

| | | | | | |
|---|---|---|---|---|---|
| "X" denotes not claimed examples | | | | | |

### Industrial Applicability

The light-emitting device of the present invention can be suitably used in, for example, display devices, displays (light-emitting-type flat panel displays (organic EL, inorganic EL, plasma)), backlights, electrophotography, illuminating light sources, recording light sources, exposing light sources, reading light sources, markers, interior accessories, optical communication, LEDs and fluorescent tubes.

## Claims

1. A light-emitting device comprising, in the order mentioned:
a light-emitting layer containing two or more light-emitting portions,
an interference layer,
an intermediate layer, and
and a fine concavo-convex pattern,
wherein the interference layer is formed of 2 to 100 layers, is disposed over a second surface of the light-emitting layer which surface is opposite to a first surface of the light-emitting layer, and reflects, toward the first surface, light emitted from the light-emitting layer,
wherein the fine concavo-convex pattern has a cross-sectional shape which has portions projected and recessed with respect to the light-emitting layer, and reflects light emitted from the light-emitting layer, and
wherein at least part of the intermediate layer fills in the spaces of the concavo-convex pattern and has a refractive index of 0.9n to 2.0n, where n denotes a refractive index of the two or more light-emitting portions with respect to light which has a main light-emitting wavelength and is emitted from the light-emitting layer.

2. The light-emitting device according to claim 1, wherein the fine concavo-convex pattern has a pitch interval of 0.01λ to 100λ, where λ denotes a main light-emitting wavelength of light emitted from the light-emitting layer.

3. The light-emitting device according to claim 1 or 2, wherein the fine concavo-convex pattern is made of heat-mode resist.

4. The light-emitting device according to any one of claims 1 to 3, wherein the fine concavo-convex pattern comprises a reflective layer.

5. The light-emitting device according to any one of claims 1 to 4, wherein a material for the interference layer is any one of TiO₂, SiO₂, SiN, Si₃N₄, Al₂O₃ and a mixture thereof.

6. The light-emitting device according to any one of claims 1 to 5, wherein at least one of the interference layers has an optical thickness which falls within a range of (2n₃ + 1)λ/4 ± λ/8, where λ and n₃ respectively denote a main light-emitting wavelength of light emitted from the light-emitting layer and a refractive index of the light-emitting layer with respect to light having the main light-emitting wavelength.

7. The light-emitting device according to any one of claims 1 to 6, wherein the interference layer has a thickness of 1 nm to 10,000 nm.

8. The light-emitting device according to any one of claims 4 to 7, wherein the reflective layer is laid over at least one surface of the fine concavo-convex pattern.

9. The light-emitting device according to any one of claims 1 to 8, wherein the light-emitting layer further comprises a seal layer for sealing the two or more light-emitting portions, and wherein a material of the seal layer is any of an acrylic resin, an epoxy resin, a fluorine-containing resin, a silicone resin, a rubber resin and an ester resin.

10. The light-emitting device according to any one of claims 1 to 9, wherein the two or more light-emitting portions are organic EL devices.

11. A production method for the light-emitting device according to any one of claims 1 to 10, comprising:
forming a light-emitting layer containing two or more light-emitting portions,
forming an interference layer over a second surface of the light-emitting layer which surface is opposite to a first surface of the light-emitting layer, the interference layer reflecting, toward the first surface, light emitted from the light-emitting layer, and
forming, over the interference layer, a fine concavo-convex pattern having a cross-sectional shape which has portions projected and recessed with respect to the light-emitting layer, the fine concavo-convex pattern reflecting light emitted from the light-emitting layer,
wherein the fine concavo-convex pattern is formed through heat-mode lithography.

12. A display comprising: the light-emitting device according to any one of claims 1 to 10.

## Patentansprüche

1. Eine lichtemittierende Vorrichtung umfassend in genannter Reihenfolge:
eine lichtemittierende Schicht umfassend zwei oder mehr lichtemittierende Abschnitte,
eine Interferenzschicht,
eine Zwischenschicht, und
eine feine konkav-konvexe Struktur,
wobei die Interferenzschicht aus 2 bis 100 Schichten aufgebaut ist, angeordnet über einer zweiten Oberfläche der lichtemittierenden Schicht, wobei diese Oberfläche zu einer ersten Oberfläche der lichtemittierenden Schicht gegenüberliegend angeordnet ist, und in Richtung der ersten Oberfläche von der lichtemittierenden Schicht emittiertes Licht reflektiert,
wobei die feine konkav-konvexe Struktur eine Querschnittsform mit herausragenden und tiefen Abschnitten in Bezug auf die lichtemittierende Schicht aufweist und von der lichtemittierenden Schicht emittiertes Licht reflektiert, und
wobei zumindest ein Teil der Zwischenschicht die Zwischenräume der konkav-konvexen Struktur füllt und einen Brechungsindex von 0,9n bis 0,2n aufweist, wobei n einen Brechungsindex der zwei oder mehr lichtemittierenden Abschnitte in Bezug auf Licht mit der hauptsächlich lichtemittierten Wellenlänge, emittiert von der lichtemittierenden Schicht, bezeichnet.

2. Lichtemittierende Vorrichtung nach Anspruch 1, wobei die feine konkav-konvexe Struktur ein Vertiefungsintervall von 0,01 λ bis 100 λ aufweist, wobei λ eine hauptsächlich lichtemittierte Wellenlänge des Lichtes, emittiert von der lichtemittierenden Schicht, bezeichnet.

3. Lichtemittierende Vorrichtung nach Anspruch 1 oder 2, wobei die feine konkav-konvexe Struktur aus Wärmeresist (heat-mode resist) ist.

4. Lichtemittierende Vorrichtung nach einem der Ansprüche 1 bis 3, wobei die feine konkav-konvexe Struktur eine reflektierende Schicht umfasst.

5. Lichtemittierende Vorrichtung nach einem der Ansprüche 1 bis 4, wobei ein Material für die Interferenzschicht ein beliebiges ist aus TiO₂, SiO₂, SiN, Si₃N₄, Al₂O₃ und einer Mischung daraus.

6. Lichtemittierende Vorrichtung nach einem der Ansprüche 1 bis 5, wobei mindestens eine der Interferenzschichten eine optische Dicke aufweist, die in einen Bereich von (2n₃ + 1) λ/4 ± λ/8 fällt, wobei λ und n₃ jeweils eine hauptsächlich lichtemittierte Wellenlänge des Lichtes, emittiert von der lichtemittierenden Schicht und einen Brechungsindex der lichtemittierenden Schicht in Bezug auf das Licht mit der hauptsächlich lichtemittierten Wellenlänge, bezeichnen.

7. Lichtemittierende Vorrichtung nach einem der Ansprüche 1 bis 6, wobei die Interferenzschicht eine Dicke von 1 nm bis 10.000 nm aufweist.

8. Lichtemittierende Vorrichtung nach einem der Ansprüche 4 bis 7, wobei die reflektierende Schicht über zumindest einer der Oberflächen der feinen konkav-konvexen Struktur gelegen ist.

9. Lichtemittierende Vorrichtung nach einem der Ansprüche 1 bis 8, wobei die lichtemittierende Schicht weiterhin eine Versiegelungsschicht zum Versiegeln der zwei oder mehr lichtemittierenden Abschnitte umfasst, und wobei ein Material der Versiegelungsschicht ausgewählt ist aus einem Acrylharz, einem Epoxidharz, einem Fluor-enthaltenden Harz, einem Silikonharz, einem Kautschukharz und einem Esterharz.

10. Lichtemittierende Vorrichtung nach einem der Ansprüche 1 bis 9, wobei die zwei oder mehr lichtemittierenden Abschnitte organische EL Bauteile sind.

11. Ein Herstellungsverfahren für die lichtemittierende Vorrichtung gemäß einem der Ansprüche 1 bis 10, umfassend:
bilden einer lichtemittierenden Schicht mit zwei oder mehr lichtemittierenden Abschnitten,
bilden einer Interferenzschicht über einer zweiten Oberfläche der lichtemittierenden Schicht deren Oberfläche zu einer ersten Oberfläche der lichtemittierenden Schicht gegenüberliegend ist,
die Interferenzschicht reflektierend das Licht emittiert von der lichtemittierenden Schicht in Richtung der ersten Oberfläche, und
bilden über der Interferenzschicht einer feinen konkav-konvexen Struktur mit einer Querschnittsform aufweisend herausragende und vertiefte Abschnitte in Bezug auf die lichtemittierende Schicht, die feine konkave-konvexe Struktur reflektiert Licht, emittiert von der lichtemittierenden Schicht,
wobei die feine konkav-konvexe Struktur durch wärmeinduzierte Lithographie gebildet wird.

12. Ein Display umfassend die lichtemittierende Vorrichtung gemäß einem der Ansprüche 1 bis 10.

## Revendications

1. Dispositif électroluminescent comportant, dans l'ordre indiqué :
une couche électroluminescente contenant deux ou plus de deux portions électroluminescentes,
une couche d'interférence,
une couche intermédiaire, et
un motif concavo-convexe fin,
dans lequel la couche d'interférence est formée de 2 à 100 couches, est disposée au-dessus d'une seconde surface de la couche électroluminescente, laquelle surface est opposée à une première surface de la couche électroluminescente et réfléchit, en direction de la première surface, de la lumière émise à partir de la couche électroluminescente,
dans lequel le motif concavo-convexe fin a une forme de section transversale qui a des portions saillantes et renfoncées par rapport à la couche électroluminescente, et réfléchit la lumière émise à partir de la couche électroluminescente, et
dans lequel au moins une partie de la couche intermédiaire remplit les espaces du motif concavo-convexe et a un indice de réfraction de 0,9n à 2,0n, où n représente un indice de réfraction des deux ou plus de deux portions électroluminescentes par rapport à la lumière qui a une longueur d'onde principale d'émission de lumière et est émise à partir de la couche électroluminescente.

2. Dispositif électroluminescent selon la revendication 1, dans lequel le motif concavo-convexe fin a un intervalle de pas de 0,01λ à 100λ, où λ représente une longueur d'onde principale d'émission de la lumière émise à partir de la couche électroluminescente.

3. Dispositif électroluminescent selon la revendication 1 ou 2, dans lequel le motif concavo-convexe fin est constitué d'une réserve d'absorption de lumière.

4. Dispositif électroluminescent selon l'une quelconque des revendications 1 à 3, dans lequel le motif concavo-convexe fin comporte une couche réflectrice.

5. Dispositif électroluminescent selon l'une quelconque des revendications 1 à 4, dans lequel un matériau pour la couche d'interférence est un élément quelconque parmi TiO₂, SiO₂, SiN, Si₃N₄, Al₂O₃ et un mélange de ceux-ci.

6. Dispositif électroluminescent selon l'une quelconque des revendications 1 à 5, dans lequel au moins l'une des couches d'interférence a une épaisseur optique qui se situe sur une plage de (2n₃+1)λ/4 ± λ/8, où λ et n₃ représentent respectivement une longueur d'onde principale d'émission de la lumière émise à partir de la couche électroluminescente et un indice de réfraction de la couche électroluminescente par rapport à la lumière ayant la longueur d'onde principale d'émission de lumière.

7. Dispositif électroluminescent selon l'une quelconque des revendications 1 à 6, dans lequel la couche d'interférence a une épaisseur de 1 nm à 10 000 nm.

8. Dispositif électroluminescent selon l'une quelconque des revendications 4 à 7, dans lequel la couche réflectrice est déposée sur au moins une surface du motif concavo-convexe fin.

9. Dispositif électroluminescent selon l'une quelconque des revendications 1 à 8, dans lequel la couche électroluminescente comporte en outre une couche d'étanchéité pour rendre étanches les deux ou plus de deux portions électroluminescentes, et dans lequel un matériau de la couche d'étanchéité est un matériau quelconque parmi une résine acrylique, une résine époxyde, une résine fluorée, une résine siliconée, une résine de caoutchouc et une résine à esters.

10. Dispositif électroluminescent selon l'une quelconque des revendications 1 à 9, dans lequel les deux ou plus de deux portions électroluminescentes sont des dispositifs EL organiques.

11. Procédé de production pour le dispositif électroluminescent selon l'une quelconque des revendications 1 à 10, comportant les étapes consistant à :
former une couche électroluminescente contenant deux ou plus de deux portions électroluminescentes,
former une couche d'interférence au-dessus d'une seconde surface de la couche électroluminescente, laquelle surface est opposée à une première surface de la couche électroluminescente, la couche d'interférence réfléchissant, en direction de la première surface, la lumière émise à partir de la couche électroluminescente, et
former, au-dessus de la couche d'interférence, un motif concavo-convexe fin ayant une forme de section transversale qui a des portions saillantes et renfoncées par rapport à la couche électroluminescente, le motif concavo-convexe fin réfléchissant la lumière émise à partir de la couche électroluminescente,
dans lequel le motif concavo-convexe fin est formé par lithographie à absorption de lumière.

12. Afficheur comportant le dispositif électroluminescent selon l'une quelconque des revendications 1 à 10.
